# EUROPEAN PATENT APPLICATION

(11) **EP 4 660 765 A1**
(43) Date of publication of application: **10.12.2025**
(21) Application number: 25180132.0
(22) Date of filing: 02.06.2025
(51) Int. Cl.: G06F 3/041, G06F 3/044, H10K 59/40

(54) **DISPLAY DEVICE INCLUDING AN INPUT SENSOR AND ELECTRONIC DEVICE INCLUDING THE SAME**

(30) Priority: 04.06.2024 KR 20240073059
(71) Applicant: Samsung Display Co., Ltd., Gyeonggi-Do (KR)
(72) Inventor: LI, Xinxing, Yongin-si (KR)
(74) Representative: Marks & Clerk LLP

(57) **Abstract**

A display device includes a display panel which includes an organic layer, a light emitting element disposed on the organic layer, and a thin-film encapsulation layer which seals the light emitting element, and an input sensor disposed on the display panel. The input sensor includes a sensing electrode including a line element which defines an opening area corresponding to the light emitting element. The light emitting element includes a first light emitting element which provides a first light emitting area having a first surface area, and a second light emitting element which provides a second light emitting area having a second surface area that is greater than the first surface area. A first distance between the first light emitting element and the input sensor is less than a second distance between the second light emitting element and the input sensor in a thickness direction of the display device.

## Description

### TECHNICAL FIELD

The present disclosure relates to a display device, and more particularly, to a display device including an input sensor and an electronic device including a display device and an input sensor.

### DISCUSSION OF THE RELATED ART

Various display devices, such as televisions, mobile phones, tablet computers, navigation units, and portable game consoles, are continuously being developed. These devices often feature input options such as keyboards, mice, and similar peripherals. Additionally, many of these display devices incorporate input sensors for user interaction.

### SUMMARY

The present disclosure provides a display device and electronic device with improved display quality.

A display device includes a display panel including an organic layer, a light emitting element disposed on the organic layer, and a thin-film encapsulation layer which seals the light emitting element. An input sensor is disposed on the display panel. The input sensor includes a sensing electrode including a line element which defines an opening area corresponding to the light emitting element. The light emitting element includes a first light emitting element which provides a first light emitting area having a first surface area, and a second light emitting element which provides a second light emitting area having a second surface area that is greater than the first surface area. A first distance between the first light emitting element and the input sensor is less than a second distance between the second light emitting element and the input sensor in a thickness direction of the display device.

The organic layer may include a first area overlapping the first light emitting element, and a second area overlapping the second light emitting element. A thickness of the first area may be greater than a thickness of the second area.

The first area and the second area of the organic layer may together have a single integrated body, and a step may be defined between the first area and the second area of the organic layer.

An electrode of the first light emitting element may be in contact with the first area of the organic layer, and an electrode of the second light emitting element may be in contact with the second area of the organic layer.

The thin-film encapsulation layer may include a first area overlapping the first light emitting element, and a second area overlapping the second light emitting element, and a thickness of the first area of the thin-film encapsulation layer may be less than a thickness of the second area of the thin-film encapsulation layer.

A distance between the line element and the first light emitting area may be equal to a distance between the line element and the second light emitting area.

The display device may further include a pixel defining layer disposed on the organic layer, and each of the first light emitting element and the second light emitting element may include a first electrode, a second electrode, and a light emitting layer disposed between the first electrode and the second electrode. A first opening which exposes the first electrode of the first light emitting element, and a second opening which exposes the first electrode of the second light emitting element may be defined in the pixel defining layer. The first electrode of the first light emitting element, which is exposed by the first opening, may be defined as the first light emitting area, and the first electrode of the second light emitting element, which is exposed by the second opening, may be defined as the second light emitting area.

The line element may include a first line element extending in a first direction, and a second line element extending in a second direction crossing the first direction. Each of the first light emitting area and the second light emitting area may have a first width in the first direction and a second width in the second direction. The first width of the first light emitting area may be equal to the first width of the second light emitting area, and the second width of the first light emitting area may be less than the second width of the second light emitting area.

A distance between the second line element and the second light emitting area may be greater than a distance between the second line element and the first light emitting area.

A distance between the second line element and the first light emitting area may be equal to a distance between the second line element and the second light emitting area, and the first width of the second light emitting area may be greater than the first width of the first light emitting area.

The input sensor may further include a first insulation layer, a second insulation layer disposed on the first insulation layer, and a third insulation layer disposed on the second insulation layer. The sensing electrode may include first sensing portions, a bridge pattern which connects adjacent portions of the first sensing portions, second sensing portions, and an intermediate portion which disposed between adjacent portions of the second sensing portions. The bridge pattern may be disposed between the first insulation layer and the second insulation layer, and the first sensing portions, the intermediate portion, and the second sensing portions may be disposed between the second insulation layer and the third insulation layer.

The first insulation layer may include an inorganic material, and the second insulation layer may include an organic material and may provide a flat surface.

The light emitting element may further include a third light emitting element which provides a third light emitting area having a third surface area that is greater than the second surface area. A third distance between the third light emitting element and the input sensor may be greater than the second distance between the second light emitting element and the input sensor.

The third light emitting element may be spaced apart from the first light emitting element and the second light emitting element in a first direction, and the first light emitting element and the second light emitting element may be spaced apart from each other in a second direction crossing the first direction.

An electronic device includes a display panel which includes an organic layer, a light emitting element disposed on the organic layer, and a thin-film encapsulation layer which seals the light emitting element, an input sensor disposed on the display panel, and a processor configured to control the display panel and the input sensor. The input sensor includes a sensing electrode including a line element which defines an opening area corresponding to the light emitting element. The light emitting element includes a first light emitting element which provides a first light emitting area having a first surface area, and a second light emitting element which provides a second light emitting area having a second surface area that is greater than the first surface area. The organic layer includes a first area overlapping the first light emitting element, and a second area overlapping the second light emitting element. A thickness of the first area is greater than a thickness of the second area.

The thin-film encapsulation layer may include inorganic encapsulation layers and an organic encapsulation layer disposed between the inorganic encapsulation layers. The organic encapsulation layer may include a first area overlapping the first light emitting element, and a second area overlapping the second light emitting element, and a thickness of the first area of the organic encapsulation layer may be less than a thickness of the second area of the organic encapsulation layer.

A distance between the line element and the first light emitting area may be equal to a distance between the line element and the second light emitting area.

The line element may include a first line element extending in a first direction, and a second line element extending in a second direction crossing the first direction, and each of the first light emitting area and the second light emitting area may have a first width in the first direction and a second width in the second direction. The first width of the first light emitting area may be equal to the first width of the second light emitting area, and the second width of the first light emitting area may be less than the second width of the second light emitting area.

A distance between the second line element and the second light emitting area may be greater than a distance between the second line element and the first light emitting area.

A distance between the second line element and the first light emitting area may be equal to a distance between the second line element and the second light emitting area, and the first width of the second light emitting area may be greater than the first width of the first light emitting area.

At least some of the above and other features of the invention are set out in the claims.

### BRIEF DESCRIPTION OF THE FIGURES

The accompanying drawings are included to provide a further understanding of the inventive concept, and are incorporated in and constitute a part of this specification. The drawings illustrate embodiments of the inventive concept and, together with the description, serve to explain principles of the inventive concept. In the drawings:
FIG. 1 is a perspective view of a display device according to an embodiment of the inventive concept;
FIG. 2 is a cross-sectional view of a display device according to an embodiment of the inventive concept;
FIG. 3 is a plan view of a display panel according to an embodiment of the inventive concept;
FIGS. 4A and 4B are enlarged plan views of a display area of a display panel according to an embodiment of the inventive concept;
FIG. 5 is a cross-sectional view of a display device according to an embodiment of the inventive concept;
FIG. 6A is a plan view of an input sensor according to an embodiment of the inventive concept;
FIG. 6B is a cross-sectional view of an input sensor corresponding to line II-II' in FIG. 6A;
FIGS. 7A and 7B are views illustrating a spherical coordinate system defined in a display device;
FIG. 7C is a cross-sectional view illustrating a radiation path of source light;
FIG. 7D is an enlarged plan view of a partial area in FIG. 4A;
FIGS. 7E and 7F are plan views illustrating shielding areas of light emitting areas;
FIG. 8 is a cross-sectional view of a display device according to an embodiment of the inventive concept;
FIGS. 9 and 10 are cross-sectional views of a display device according to an embodiment of the inventive concept;
FIG. 11 is a plan view of a display device according to an embodiment of the inventive concept; and
FIG. 12 is a diagram illustrating an electronic device according to an embodiment of the present invention.

### DETAILED DESCRIPTION

In this specification, it will be understood that when an element (or region, layer, section, etc.) is referred to as being "on", "connected to" or "coupled to" another element, it can be disposed directly on, connected or coupled to the other element or a third element may be disposed between the elements.

Like reference numbers or symbols may refer to like elements throughout the specification and the drawings. In addition, while each drawing may represent one or more particular embodiments of the present disclosure, drawn to scale, such that the relative lengths, thicknesses, and angles can be inferred therefrom, it is to be understood that the present invention is not necessarily limited to the relative lengths, thicknesses, and angles shown. Changes to these values may be made within the scope of the present disclosure, for example, to allow for manufacturing limitations and the like. The term "and/or" includes one or more combinations which may be defined by relevant elements.

It will be understood that, although the terms first, second, etc. may be used herein to describe various elements, these elements should not necessarily be limited by these terms. These terms are used to distinguish one element from another element. For example, a first element could be termed a second element without departing from the teachings of the present invention, and similarly, a second element could be termed a first element. As used herein, the singular forms are intended to include the plural forms as well, unless the context clearly indicates otherwise.

In addition, the terms, such as "below", "beneath", "on" and "above", are used for explaining the relation of elements shown in the drawings. The terms are relative concept and are explained based on the direction shown in the drawing.

It will be further understood that the terms such as "includes" or "has", when used herein, specify the presence of stated features, numerals, steps, operations, elements, parts, or the combination thereof, but do not preclude the presence or addition of one or more other features, numerals, steps, operations, elements, parts, or the combination thereof.

Hereinafter, embodiments of the inventive concept will be described with reference to the accompanying drawings.

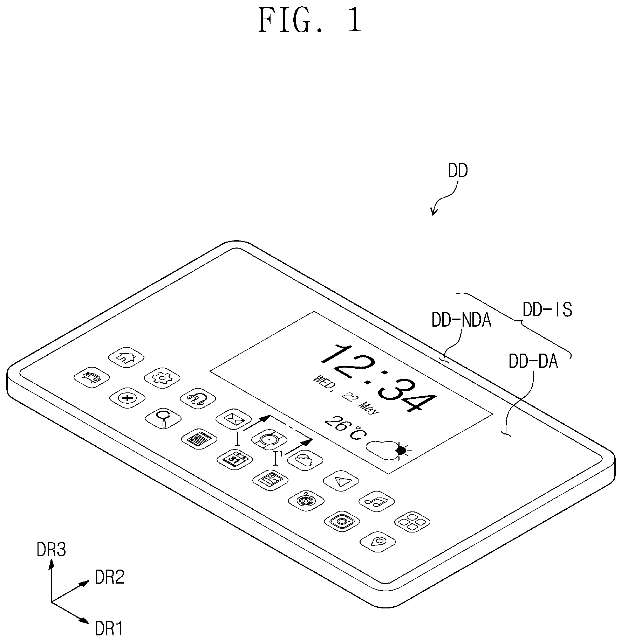

FIG. 1 is a perspective view of a display device DD according to an embodiment of the inventive concept. As illustrated in FIG. 1, the display device DD may display an image through a display surface DD-IS. The display surface DD-IS is parallel to a plane defined by a first direction DR1 and a second direction DR2. A normal direction to the display surface DD-IS, i.e., a thickness direction of the display device DD, is indicated by a third direction DR3.

A front surface (or top surface) and a rear surface (or bottom surface) of elements shown and described herein are defined based on the third direction DR3. However, the first to third directions DR1, DR2 and DR3 illustrated in this embodiment are just examples.

The display device DD including a planar display surface is illustrated in an embodiment of the inventive concept, but the embodiment of the inventive concept is not necessarily limited thereto. For example, the display device DD may include a curved display surface or a three-dimensional display surface. The three-dimensional display surface may include a plurality of display areas oriented in different directions, and include, for example, a bent display surface. The display device DD according to this embodiment may be a flexible display device DD. The flexible display device DD may be a foldable display device which is capable of being folded to a noticeable extent without cracking or otherwise sustaining damage.

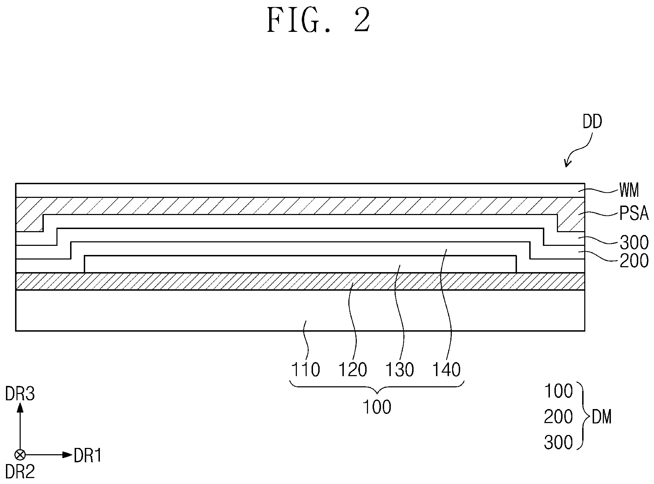

In this embodiment, the display device DD applied to a tablet computer is illustrated as an example. Electronic modules, a camera module, a power module, and the like, which are mounted on a main board, may be disposed in a bracket/case or the like together with the display device DD, thereby constituting the tablet computer. One of the electronic modules may include a processor is configured to control the display device (DD). The processor may control a display module (DM), i.e., a display panel (100) and an input sensor (200), as described with reference to FIG. 2. The display device DD, according to an embodiment of the inventive concept, may be applied to a large-sized electronic device such as a television or a computer monitor, and also to a small and medium-sized electronic device such as a mobile phone, a vehicle navigation unit, a portable game console, or a smart watch.

As illustrated in FIG. 1, the display surface DD-IS includes an image area DD-DA on which an image is displayed, and a bezel area DD-NDA adjacent to the image area DD-DA. The bezel area DD-NDA is an area on which an image is not displayed. FIG. 1 illustrates icon images as one example of the image that is displayed.

As illustrated in FIG. 1, the image area DD-DA may have a substantially rectangular shape. The "substantially rectangular shape" includes not only a mathematical rectangular shape, but also a rectangular shape that has rounded corners (i.e., a rounded rectangle).

The bezel area DD-NDA may surround the image area DD-DA. However, an embodiment of the inventive concept is not necessarily limited thereto, and a shape of the bezel area DD-NDA may be changed. For example, the bezel area DD-NDA may be disposed at only one side of the image area DD-DA.

FIG. 2 is a cross-sectional view of a display device DD according to an embodiment of the inventive concept.

The display device DD may include a display module DM and a window WM disposed on the display module DM. The display module DM and the window WM may be coupled to each other through an adhesive layer PSA. According to an embodiment of the inventive concept, the window WM may be formed by a coating method to be in contact with the display module DM, and here, the adhesive layer PSA may be omitted.

The display module DM may include a display panel 100, an input sensor 200, and an anti-reflective layer 300. The display panel 100 may include a base layer 110, a driving element layer 120, a light emitting element layer 130, and a thin-film encapsulation layer 140.

The base layer 110 has a top surface on which the driving element layer 120 is disposed. The base layer 110 may be a flexible substrate which is capable of being bent, folded, rolled or the like. The base layer 110 may be a glass substrate, a metal substrate, a polymer substrate, or the like. However, an embodiment of the inventive concept is not necessarily limited thereto, and the base layer 110 may be an inorganic layer, an organic layer, or a composite material layer. The base layer 110 has substantially the same shape as the display panel 100.

The base layer 110 may have a multilayer structure. For example, the base layer 110 may include a first synthetic resin layer, a second synthetic resin layer, and inorganic layers disposed between the first and second synthetic resin layers. Each of the first and second synthetic resin layers may include a polyimide-based resin and is not necessarily particularly limited thereto.

The driving element layer 120 may be disposed on the base layer 110. The driving element layer 120 may include a plurality of insulation layers, a plurality of semiconductor patterns, a plurality of conductive patterns, signal lines, and the like. The driving element layer 120 may include a driving circuit of a pixel.

The light emitting element layer 130 may be disposed on the driving element layer 120. The light emitting element layer 130 may include a light emitting element. For example, the light emitting element may include an organic light emitting material, an inorganic light emitting material, an organic-inorganic light emitting material, a quantum dot, a quantum rod, a micro LED, or a nano LED.

The thin-film encapsulation layer 140 may be disposed on the light emitting element layer 130. The thin-film encapsulation layer 140 may protect the light emitting element layer 130, i.e., the light emitting element, from moisture, oxygen, and foreign matter such as dust particles. The thin-film encapsulation layer 140 may include at least one inorganic encapsulation layer. The thin-film encapsulation layer 140 may include a stack structure of a first inorganic encapsulation layer/an organic encapsulation layer/a second inorganic encapsulation layer.

The input sensor 200 may be disposed directly on the display panel 100. The input sensor 200 may detect a user's input by using, for example, an electromagnetic induction method and/or a capacitance method. The display panel 100 and the input sensor 200 may be formed through a continuous process. Here, the phrase "being disposed directly" may mean that a third component is not disposed between the input sensor 200 and the display panel 100. For example, a separate adhesive layer might not be disposed between the input sensor 200 and the display panel 100.

The anti-reflective layer 300 reduces reflectance of external light incident from above the window WM. The anti-reflective layer 300, according to an embodiment of the inventive concept, may include a retarder and a polarizer. The retarder may be a film type or a liquid crystal coating type, and may include a λ/2 retarder (e.g., a half-wave plate) and/or a λ/4 retarder (e.g., a quarter-wave plate). The polarizer may also be a film type or a liquid crystal coating type. The film type may include a stretchable synthetic resin film, and the liquid crystal coating type may include liquid crystals arranged in a predetermined arrangement. The retarder and the polarizer may further include a protective film. The retarder and the polarizer themselves or the protective film may be defined as a base layer of the anti-reflective layer 300.

The anti-reflective layer 300, according to an embodiment of the inventive concept, may include a color filters. The color filters have a predetermined arrangement. An arrangement of a plurality of groups of color filters divided based on colors may be determined in consideration of an arrangement of a plurality of groups of pixels divided based on emissive colors. The anti-reflective layer 300 may further include a black matrix adjacent to the color filters. The anti-reflective layer 300 including the color filters may be disposed directly on the display panel 100.

The window WM, according to an embodiment of the inventive concept, may include a base layer and a light blocking pattern. The base layer may include, for example, a glass substrate and/or a synthetic resin film. The light blocking pattern partially overlaps the base layer. The light blocking pattern may be disposed on a rear surface of the base layer, and the light blocking pattern may substantially define the bezel area DD-NDA (see FIG. 1) of the display device DD. An area on which the light blocking pattern is not disposed may define the image area DD-DA (see FIG. 1) of the display device DD.

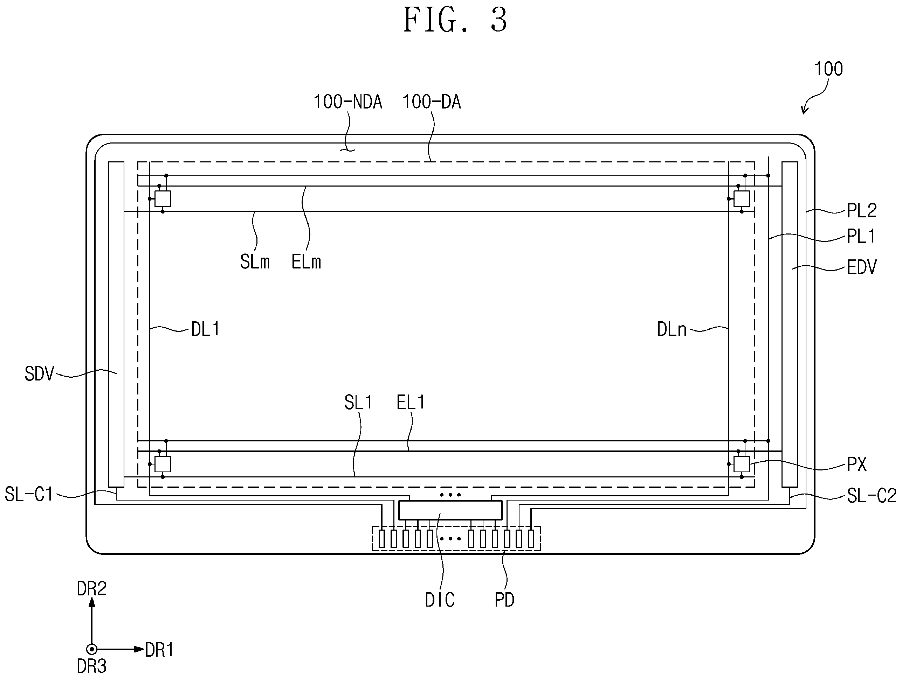

FIG. 3 is a plan view of a display panel 100 according to an embodiment of the inventive concept.

Referring to FIG. 3, the display panel 100 may include a plurality of pixels PX, a scan driving circuit SDV, a light emission driving circuit EDV, a plurality of signal lines, and a plurality of pads PD. The plurality of pixels PX are disposed on a display area 100-DA. A driving chip DIC mounted on a non-display area 100-NDA may include a data driving circuit. The display area 100-DA may correspond to the image area DD-DA in FIG. 1, and the non-display area 100-NDA may correspond to the bezel area DD-NDA in FIG. 1. In the present disclosure, "an area or portion corresponding to another area or portion" means that the area or portion overlaps the other area or portion, and is not necessarily limited to the meaning that two different areas or portions have the same shape and the same surface area. In an embodiment of the inventive concept, like the scan driving circuit SDV and the light emission driving circuit EDV, the data driving circuit may also be integrated into the display panel 100.

The plurality of signal lines may include a plurality of scan lines SL1 to SLm, a plurality of data lines DL1 to DLn, a plurality of light emitting lines EL1 to ELm, first and second control lines SL-C1 and SL-C2, and first and second power lines PL1 and PL2. Here, m and n are each integers of 2 or more.

The scan lines SL1 to SLm may extend in the first direction DR1 to be electrically connected to the pixels PX and the scan driving circuit SDV. The data lines DL1 to DLn may extend in the second direction DR2 to be electrically connected to the pixels PX and the driving chip DIC. The light emitting lines EL1 to ELm may extend in the first direction DR1 to be electrically connected to the pixels PX and the light emission driving circuit EDV.

The first power line PL1 receives a first power voltage, and the second power line PL2 receives a second power voltage having a lower level than the first power voltage. Although not illustrated, a second electrode (e.g., cathode) of a light emitting element is electrically connected to the second power line PL2.

The first control line SL-C1 may be connected to the scan driving circuit SDV, and extend toward a lower end of the display panel 100. The second control line SL-C2 may be connected to the light emission driving circuit EDV, and extend toward the lower end of the display panel 100. The pads PD may be disposed on the non-display area 100-NDA adjacent to the lower end of the display panel 100, and be closer to the lower end of the display panel 100 than the driving chip DIC is. The pads PD may be connected to the driving chip DIC and some of the signal lines.

The scan driving circuit SDV may generate a plurality of scan signals, and the scan signals may be applied to the pixels PX through the scan lines SL1 to SLm. The driving chip DIC may generate a plurality of data voltages, and the data voltages may be applied to the pixels PX through the data lines DL1 to DLn. The light emission driving circuit EDV may generate a plurality of light emitting signals, and the light emitting signals may be applied to the pixels PX through the light emitting lines EL1 to ELm. The pixels PX may receive the data voltages in response to the scan signals. The pixels PX may display an image by emitting light with luminance corresponding to the data voltages in response to the light emitting signals.

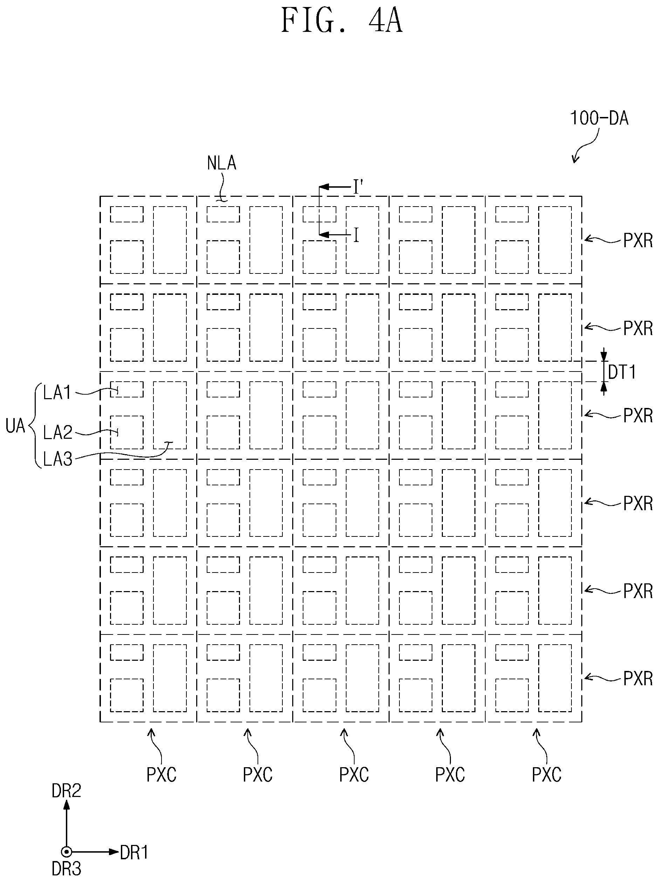

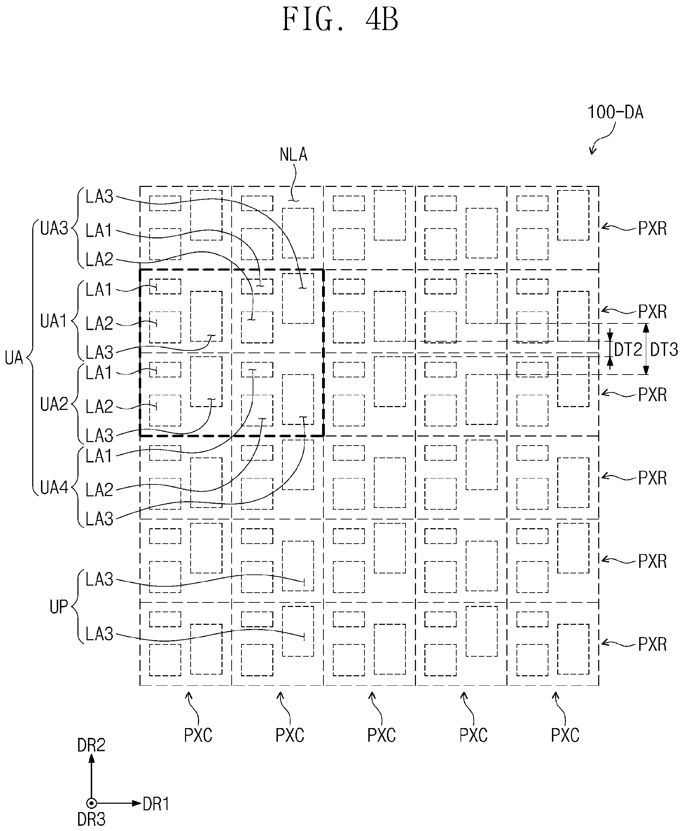

FIGS. 4A and 4B are enlarged plan views of a display area 100-DA according to an embodiment of the inventive concept.

Referring to FIG. 4A, the display area 100-DA may include a plurality of light emitting areas LA1, LA2 and LA3, and a non-light-emitting area NLA adjacent to the plurality of light emitting areas LA1, LA2 and LA3. The non-light-emitting area NLA sets a boundary of the light emitting areas LA1, LA2 and LA3.

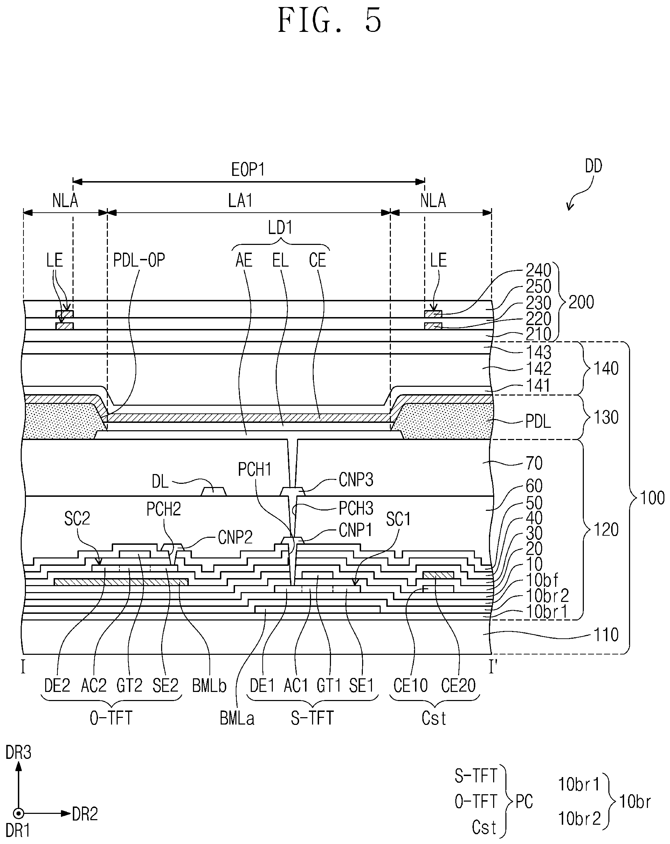

The light emitting areas LA1, LA2 and LA3 may correspond in a one-to-one manner to the pixels PX in FIG. 3. Each of the pixels may include a light emitting element, and the light emitting areas LA1, LA2 and LA3 may be each an area from which light generated by the light emitting element is emitted. An arrangement relationship between the light emitting areas LA1, LA2 and LA3 and the non-light-emitting area NLA will be described later with reference to FIG. 5.

The light emitting areas LA1, LA2 and LA3 may be divided into a plurality of groups divided based on emissive colors. The light emitting areas LA1, LA2 and LA3 may include first light emitting areas LA1 (or first color light-emitting areas), each of which generates first color light, second light emitting areas LA2 (or second color light-emitting areas), each of which generates second color light, and third light emitting areas LA3 (or third color light-emitting areas), each of which generates third color light. In this embodiment, the first color light may be red light, the second color light may be green light, and the third color light may be blue light.

A surface area may be different among the first light emitting area LA1, the second light emitting area LA2, and the third light emitting area LA3. In this embodiment, the first light emitting area LA1 may have the smallest surface area, and the third light emitting area LA3 may have the largest surface area.

The first light emitting areas LA1, the second light emitting areas LA2, and the third light emitting areas LA3 may be arranged according to a predetermined rule. A unit area UA is a repeating array unit of the first to third light emitting areas LA1, LA2 and LA3 disposed in the display area 100-DA.

Referring to FIG. 4A, one type of unit area UA is disposed in the display area 100-DA. A plurality of unit areas UA may be arranged in the form of a matrix. The unit area UA includes the first light emitting area LA1, the second light emitting area LA2, and the third light emitting area LA3. In the unit area UA, the third light emitting area LA3 is disposed at one side of the first light emitting area LA1 and the second light emitting area LA2 in the first direction DR1. As illustrated in FIG. 4A, the third light emitting area LA3 may be disposed on the right of the first light emitting area LA1 and the second light emitting area LA2. The first light emitting area LA1 and the second light emitting area LA2 are spaced apart from each other in the second direction DR2. The first light emitting area LA1 and the second light emitting area LA2 may be aligned in the second direction DR2. A distance DT1 between respective third light emitting areas LA3 of adjacent unit areas UA on pixel rows PXR may be uniform.

Referring to FIG. 4B, a plurality of unit areas UA are disposed in the display area 100-DA. The plurality of unit areas UA may be arranged in the form of a matrix. Each of the unit areas UA may include a first sub-area UA1, a second sub-area UA2, a third sub-area UA3, and a fourth sub-area UA4.

Each of the first sub-area UA1, the second sub-area UA2, the third sub-area UA3, and the fourth sub-area UA4 includes a first light emitting area LA1, a second light emitting area LA2, and a third light emitting area LA3. A relative arrangement of the first light emitting area LA1 and the second light emitting area LA2 to the third light emitting area LA3 may be substantially equal to that of the unit area UA described with reference to FIG. 4A.

The first sub-area UA1 and the second sub-area UA2 may be aligned in the second direction DR2, and the third sub-area UA3 and the fourth sub-area UA4 may be aligned in the second direction DR2. The third sub-area UA3 is disposed at one side (on the right in FIG. 4B) of the first sub-area UA1 in the first direction DR1, and the fourth sub-area UA4 is disposed at the one side (on the right in FIG. 4B) of the second sub-area UA2 in the first direction DR1.

A position of the third light emitting area LA3 relative to the first light emitting area LA1 and the second light emitting area LA2 in the second direction DR2 is different between the first sub-area UA1 and the second sub-area UA2. Referring to the first sub-area UA1, the position of the third light emitting area LA3 relative to the first light emitting area LA1 and the second light emitting area LA2 in the second direction DR2 is disposed at a lower side. Referring to the second sub-area UA2, the position of the third light emitting area LA3 relative to the first light emitting area LA1 and the second light emitting area LA2 in the second direction DR2 is disposed at an upper side. A degree at which the third light emitting area LA3 is shifted with respect to the first light emitting area LA1 and the second light emitting area LA2 in the second direction DR2 may be different between the first sub-area UA1 and the second sub-area UA2. In this embodiment, the third light emitting area LA3 of the second sub-area UA2 may be shifted to a greater extent. However, an embodiment of the inventive concept is not necessarily limited thereto, and the degree at which the third light emitting area LA3 is shifted with respect to the first light emitting area LA1 and the second light emitting area LA2 in the second direction DR2 may be the same between the first sub-area UA1 and the second sub-area UA2.

In this embodiment, the third sub-area UA3 may have substantially the same arrangement of the first to third light emitting areas LA1 to LA3 as the second sub-area UA2, and the fourth sub-area UA4 may have substantially the same arrangement of the first to third light emitting areas LA1 to LA3 as the first sub-area UA1. The degree at which the third light emitting area LA3 is shifted with respect to the first light emitting area LA1 and the second light emitting area LA2 in the second direction DR2 may be the same between the first sub-area UA1 and the fourth sub-area UA4. The degree at which the third light emitting area LA3 is shifted with respect to the first light emitting area LA1 and the second light emitting area LA2 in the second direction DR2 may be the same between the second sub-area UA2 and the third sub-area UA3.

In the unit area UA, the third light emitting area LA3 of the first sub-area UA1 and the third light emitting area LA3 of the second sub-area UA2 are spaced a second distance DT2 from each other to be disposed relatively close to each other. The third light emitting area LA3 of the first sub-area UA1 and the third light emitting area LA3 of the second sub-area UA2, which are spaced the second distance DT2 from each other, define a pair UP of light emitting areas in the unit area UA.

In the unit area UA, the third light emitting area LA3 of the third sub-area UA3 and the third light emitting area LA3 of the fourth sub-area UA4 are spaced a third distance DT3 from each other to be disposed relatively far from each other. The third distance DT3 is greater than the second distance DT2.

The third light emitting area LA3 of the third sub-area UA3 in one of the unit areas UA may define the pair UP of light emitting areas together with the third light emitting area LA3 of the fourth sub-area UA4 in another unit area UA disposed on a different pixel row PXR and disposed on the same pixel column PXC from/as the one of the unit areas UA. As illustrated in FIG. 4B, the third light emitting area LA3 of the third sub-area UA3 in one of the unit areas UA may define the pair UP of light emitting areas together with the third light emitting area LA3 of the fourth sub-area UA4 in the unit area UA disposed above the one of the unit areas UA.

As described above, the reason why the pairs UP of light emitting areas are defined is that the arrangement of the sub-areas UA1 to UA4 is different according to the pixel rows PXR. This is because, when the first sub-area UA1 and the third sub-area UA3 are alternately disposed in the first direction DR1 within an odd-numbered pixel row PXR, the second sub-area UA2 and the fourth sub-area UA4 are alternately disposed in the first direction DR1 within an even-numbered pixel row PXR.

The reason why the pairs UP of light emitting areas are formed is because of a mask used in deposition. A mask for deposition is used to form a light emitting layer having a single uninterrupted structure on a light emitting element disposed in the third light emitting area LA3 of the first sub-area UA1 and a light emitting element disposed in the third light emitting area LA3 of the second sub-area UA2. For example, the light emitting layer disposed in the third light emitting area LA3 of the first sub-area UA1 and the light emitting layer disposed in the third light emitting area LA3 of the second sub-area UA2 are together part of an uninterrupted singular structure. Openings corresponding to the pairs UP of light emitting areas are defined in the mask for deposition. An area between the openings of the mask for deposition corresponds to a blocking area of the mask for deposition. As the openings corresponding to the pairs UP of light emitting areas are defined, the number of the openings may be decreased, and a width of the blocking area of the mask for deposition disposed between the openings in the second direction DR2 may be secured. In the mask for deposition having a small thickness, the width of the blocking area in the second direction DR2 may be secured to suppress a defect in which the mask for deposition sags in a deposition process. In addition, the mask having a small number of the openings may contribute to easier production, and reduce mask defects.

FIG. 5 is a cross-sectional view of a display device DD corresponding to line I-I' in FIG. 4A. In FIG. 5, to the extent that an element, such as the anti-reflective layer 300 or the window WM, is not described in detail with respect to this figure, it may be understood that the element is at least similar to a corresponding element that has been described elsewhere within the present disclosure, for example, in FIG. 2.

A pixel driving circuit PC which drives a light emitting element LD1 may include a plurality of pixel driving elements. The pixel driving circuit PC may include a plurality of transistors S-TFT and O-TFT and a capacitor Cst. In FIG. 5, a silicon transistor S-TFT and an oxide transistor O-TFT are illustrated as an example of the transistors. The pixel driving circuit PC in FIG. 5 is just one embodiment, and components of the pixel driving circuit PC are not necessarily limited thereto. For example, the pixel driving circuit PC may include only one type of transistor among the silicon transistor S-TFT and the oxide transistor O-TFT.

Referring to FIG. 5, a base layer 110 is illustrated as a single layer. The base layer 110 may include a synthetic resin such as polyimide. In an embodiment of the inventive concept, the base layer 110 may have a multilayer structure including a first synthetic resin layer, at least one inorganic layer, and a second synthetic resin layer.

Referring to FIG. 5, a barrier layer 10br may be disposed on the base layer 110. The barrier layer 10br prevents foreign matter from being introduced from the outside. The barrier layer 10br may include at least one inorganic layer. The barrier layer 10br may include a lower barrier layer 10br1 and an upper barrier layer 10br2. A first shielding electrode BMLa may be disposed between the lower barrier layer 10br1 and the upper barrier layer 10br2. The first shielding electrode BMLa may be disposed so as to correspond to the silicon transistor S-TFT. The first shielding electrode BMLa may include a metal, for example, molybdenum. The first shielding electrode BMLa may receive a bias voltage.

A buffer layer 10bf may be disposed on the barrier layer 10br. The buffer layer 10bf may prevent a phenomenon in which metal atoms or impurities are spread from the base layer 110 to a first semiconductor pattern SC1 thereabove. The buffer layer 10bf may include at least one inorganic layer.

The first semiconductor pattern SC1 may be disposed on the buffer layer 10bf. The first semiconductor pattern SC1 may include a silicon semiconductor. For example, the silicon semiconductor may include an amorphous silicon, a polycrystalline silicon, or the like. For example, the first semiconductor pattern SC1 may include a low-temperature polysilicon.

The first semiconductor pattern SC1 may have different electrical properties depending on whether the first semiconductor pattern SP1 is doped. A source region SE1, a channel region AC1 (or active region), and a drain region DE1 of the silicon transistor S-TFT may be provided from the first semiconductor pattern SC1. The source region SE1 and the drain region DE1 may extend from the channel region AC1 in opposite directions in a cross-sectional view.

A first insulation layer 10 may be disposed on the buffer layer 10bf. The first insulation layer 10 may cover the first semiconductor pattern SC1. The first insulation layer 10 may be an inorganic layer. Not only the first insulation layer 10 but also an inorganic layer of a driving element layer 120, to be described later, may each have a single-layer structure or a multilayer structure, and may include at least one of the foregoing materials. However, an embodiment of the inventive concept is not necessarily limited thereto.

A gate GT1 of the silicon transistor S-TFT is disposed on the first insulation layer 10. The gate GT1 may be a portion of a metal pattern. The gate GT1 overlaps the channel region AC1. The gate GT1 may serve as a mask in a process of doping the first semiconductor pattern SC1. A first electrode CE10 of the storage capacitor Cst is disposed on the first insulation layer 10. The first electrode CE10 may together with the gate GT1 be formed of a single continuous structure.

A second insulation layer 20 may be disposed on the first insulation layer 10 and cover the gate GT1. In an embodiment of the inventive concept, an upper electrode overlapping the gate GT1 may be further disposed on the second insulation layer 20. A second electrode CE20 overlapping the first electrode CE10 may be disposed on the second insulation layer 20. The upper electrode may together with the second electrode CE20 be formed of a single continuous structure.

A second shielding electrode BMLb is disposed on the second insulation layer 20. The second shielding electrode BMLb may be disposed so as to correspond to the oxide transistor O-TFT. In an embodiment of the inventive concept, the second shielding electrode BMLb may be omitted. A third insulation layer 30 may be disposed on the second insulation layer 20. A second semiconductor pattern SC2 may be disposed on the third insulation layer 30. A source region SE2, a channel region AC2 (or active region), and a drain region DE2 of the oxide transistor O-TFT may be provided from the second semiconductor pattern SC2. The second semiconductor pattern SC2 may include a metal oxide semiconductor. A fourth insulation layer 40 may be disposed on the third insulation layer 30. As illustrated in FIG. 5, the fourth insulation layer 40 may cover the second semiconductor pattern SC2.

A gate GT2 of the oxide transistor O-TFT is disposed on the fourth insulation layer 40. The gate GT2 of the oxide transistor O-TFT may be a portion of a metal pattern. The gate GT2 of the oxide transistor O-TFT overlaps the channel region AC2. A fifth insulation layer 50 may be disposed on the fourth insulation layer 40, and the fifth insulation layer 50 may cover the gate GT2. Each of the first insulation layer 10 to the fifth insulation layer 50 may be an inorganic layer.

A first connection electrode CNP1 and a second connection electrode CNP2 may be disposed on the fifth insulation layer 50. The first connection electrode CNP1 and the second connection electrode CNP2 may be formed through the same process, and thus have the same material and the same stack structure. The first connection electrode CNP1 may be connected to the drain region DE1 of the silicon transistor S-TFT through a first pixel contact hole PCH1 passing through the first to fifth insulation layers 10, 20, 30, 40 and 50. The second connection electrode CNP2 may be connected to the source region SE2 of the oxide transistor O-TFT through a second pixel contact hole PCH2 passing through the fourth and fifth insulation layers 40 and 50. The respective connection relationships of the first connection electrode CNP1 and the second connection electrode CNP2 to the silicon transistor S-TFT and the oxide transistor O-TFT are not necessarily limited thereto.

A sixth insulation layer 60 may be disposed on the fifth insulation layer 50. A third connection electrode CNP3 may be disposed on the sixth insulation layer 60. The third connection electrode CNP3 may be connected to the first connection electrode CNP1 through a third pixel contact hole PCH3 passing through the sixth insulation layer 60. A data line DL may be disposed on the sixth insulation layer 60. A seventh insulation layer 70 may be disposed on the sixth insulation layer 60, and cover the third connection electrode CNP3 and the data line DL. Each of the sixth insulation layer 60 and the seventh insulation layer 70 may be an organic layer.

The light emitting element LD1 may include an anode AE (or first electrode), a light emitting layer EL, and a cathode CE (or second electrode). The anode AE of the light emitting element LD1 may be disposed on the seventh insulation layer 70. The anode AE may be a transmissive electrode, a semi-transmissive electrode, or a reflective electrode. The anode AE may include a stack structure of ITO/Ag/ITO stacked in sequence. Respective positions of the anode AE and the cathode CE may be exchanged.

A pixel defining layer PDL may be disposed on the seventh insulation layer 70. The pixel defining layer PDL may be an organic layer. The pixel defining layer PDL may have a light absorbing property, and, for example, the pixel defining layer PDL may have a black color. The pixel defining layer PDL may include a black component (black coloring agent). The black component may include a black dye or a black pigment. The black component may include a metal such as chromium, an oxide thereof, or a carbon black. The pixel defining layer PDL may correspond to a light blocking pattern having a light blocking property.

The pixel defining layer PDL may cover a portion of the anode AE. For example, an opening PDL-OP which exposes a portion of the anode AE may be defined in the pixel defining layer PDL. A light emitting area LA1 may be defined so as to correspond to the opening PDL-OP. As an example, FIG. 5 illustrates one light emitting area LA1 corresponding to the first light emitting area LA1 in FIG. 4A. For example, the portion, which is exposed by the opening PDL-OP, of the anode AE may be defined as the light emitting area LA1.

A cross-section corresponding to each of the second light emitting area LA2 and the third light emitting area LA3 in FIG. 4A may also be substantially equal to that in FIG. 5. The second light emitting area LA2 and the third light emitting area LA3 may also be defined as portions, which are exposed by openings, of anodes of light emitting elements disposed in the second light emitting area LA2 and the third light emitting area LA3, respectively.

In an embodiment of the inventive concept, a hole control layer may be disposed between the anode AE and the light emitting layer EL. The hole control layer may include a hole transport layer, and further include a hole injection layer. An electron control layer may be disposed between the light emitting layer EL and the cathode CE. The electron control layer may include an electron transport layer, and further include an electron injection layer.

A thin-film encapsulation layer 140 may cover the light emitting element LD1. The thin-film encapsulation layer 140 may include an inorganic encapsulation layer 141, an organic encapsulation layer 142, and an inorganic encapsulation layer 143 that are stacked in sequence, but layers constituting the thin-film encapsulation layer 140 are not necessarily limited thereto. The inorganic encapsulation layers 141 and 143 may each include a silicon nitride layer, a silicon oxynitride layer, a silicon oxide layer, a titanium oxide layer, an aluminum oxide layer, or the like. The inorganic encapsulation layers 141 and 143 may each have a multilayer structure. The organic encapsulation layer 142 may include an acrylic organic layer and is not necessarily limited thereto.

In this embodiment, an input sensor 200 may include at least one conductive layer (or at least one sensor conductive layer) and at least one insulation layer (or at least one sensor insulation layer). In this embodiment, the input sensor 200 may include a first insulation layer 210 (or first sensor insulation layer), a first conductive layer 220 (or first sensor conductive layer), a second insulation layer 230 (or second sensor insulation layer), a second conductive layer 240 (or second sensor conductive layer), and a third insulation layer 250 (or third sensor insulation layer). FIG. 5 schematically illustrates a line element LE of the first conductive layer 220 and a line element LE of the second conductive layer 240. The line element LE of the second conductive layer 240 may define an opening area EOP1 corresponding to the light emitting area LA1.

The first insulation layer 210 may be disposed directly on the thin-film encapsulation layer 140. The first insulation layer 210 may be an inorganic layer including at least one of a silicon nitride, a silicon oxynitride, or a silicon oxide. Each of the first conductive layer 220 and the second conductive layer 240 may have a single-layer structure, or have a multilayer structure in which layers are stacked in the third direction DR3. The first conductive layer 220 and the second conductive layer 240 may include line elements that define a mesh-shaped electrode. The line element of the first conductive layer 220 and the line element of the second conductive layer 240 may be connected to each other through a contact hole passing through the second insulation layer 230 or might not be connected to each other according to positions thereof.

The first conductive layer 220 and the second conductive layer 240 each having a single-layer structure may include a metal layer or a transparent conductive layer. The metal layer may include molybdenum, silver, titanium, copper, aluminum, or an alloy thereof. The first conductive layer 220 and the second conductive layer 240 each having a multilayer structure may include metal layers. The second insulation layer 230 may be disposed between the first conductive layer 220 and the second conductive layer 240. The third insulation layer 250 may cover the second conductive layer 240. In an embodiment of the inventive concept, the third insulation layer 250 may be omitted.

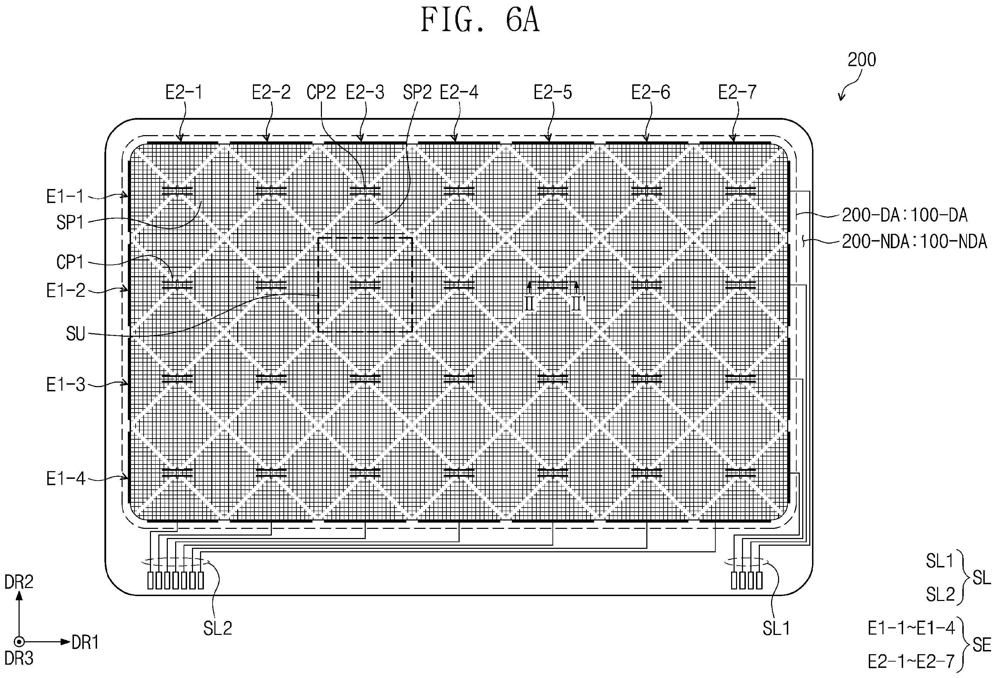

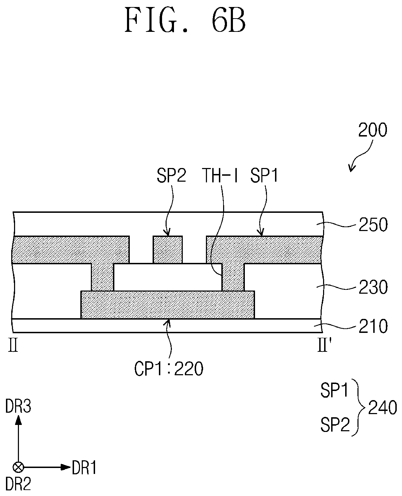

FIG. 6A is a plan view of an input sensor 200 according to an embodiment of the inventive concept. FIG. 6B is a cross-sectional view of the input sensor 200 corresponding to line II-II' in FIG. 6A.

As illustrated in FIG. 6A, the input sensor 200 includes a sensing area 200-DA and a non-sensing area 200-NDA adjacent to the sensing area 200-DA. The sensing area 200-DA and the non-sensing area 200-NDA correspond respectively to the display area 100-DA and the non-display area 100-NDA illustrated in FIG. 3. The input sensor 200 may include a sensing electrode SE and a signal line SL connected to the sensing electrode SE. In this embodiment, the sensing electrode SE may include first electrodes E1-1 to E1-4 (or first sensing electrodes), and second electrodes E2-1 to E2-7 (or second sensing electrodes), and the signal line SL may include first signal lines SL1 (or first sensor signal lines) and second signal lines SL2 (or second sensor signal lines).

The first electrodes E1-1 to E1-4 and the second electrodes E2-1 to E2-7, which are insulated and intersected with each other, are disposed in the sensing area 200-DA. The first signal lines SL1 connected to the first electrodes E1-1 to E1-4, and the second signal lines SL2 electrically connected to the second electrodes E2-1 to E2-7 are disposed in the non-sensing area 200-NDA. One of the first signal lines SL1 and the second signal lines SL2 transmits a driving signal for sensing an external input from an external circuit to corresponding electrodes, and the other outputs a sensing signal. A variation in capacitance between the first electrodes E1-1 to E1-4 and the second electrodes E2-1 to E2-7 is measured based on the sensing signal. In this embodiment, a mutual-capacitance type input sensor is illustrated as an example, but an embodiment of the inventive concept is not necessarily limited thereto. For example, a self-capacitance structure including one kind of sensing electrodes may apply to the input sensor 200. In the foregoing electrode structure, the input sensor 200 may be driven by a self-capacitance method.

In this embodiment, four first electrodes E1-1 to E1-4 and seven second electrodes E2-1 to E2-7 are illustrated as an example. In addition, the four first electrodes E1-1 to E1-4 constituting different channels, and the seven second electrodes E2-1 to E2-7 constituting different channels are illustrated as an example. In this case, 28 sensing units SU may be defined. An intersection area of corresponding first electrodes and corresponding second electrodes is disposed for each of the sensing units SU.

Referring to FIG. 6A, each of the first electrodes E1-1 to E1-4 and the second electrodes E2-1 to E2-7 may have a mesh shape in which a plurality of opening areas are defined. Each of the first electrodes E1-1 to E1-4 and the second electrodes E2-1 to E2-7 includes a line element defined by the plurality of opening areas. Each of the plurality of opening areas may overlap (or correspond to) a corresponding light emitting area of, for example, the plurality of light emitting areas LA1, LA2 and LA3 in FIG. 4A.

Any one of the first electrodes E1-1 to E1-4 and the second electrodes E2-1 to E2-7 may together be formed of a single continuous structure. In this embodiment, the second electrodes E2-1 to E2-7 having together a single uninterrupted structure are illustrated as an example. The second electrodes E2-1 to E2-7 may include sensing portions SP2 (or second sensing portions) and intermediate portions CP2. Each of the sensing portions SP2 may have a larger surface area than each of the intermediate portions CP2, and have a substantially rhombic shape. Each of the intermediate portions CP2 is disposed between two adjacent sensing portions SP2 of the sensing portions SP2. Each of the intermediate portions CP2 may have a relatively small length, and the intermediate portions CP2 may be omitted. Here, the sensing portion SP2 may extend directly from the sensing portion SP2 adjacent thereto.

Each of the first electrodes E1-1 to E1-4 may include sensing patterns SP1 (or first sensing portions) and bridge patterns CP1 (or connection patterns). Two adjacent sensing patterns SP1 may be connected to each other through two bridge patterns CP1, but the number of the bridge patterns CP1 is not necessarily limited to any particular value.

Referring to FIGS. 6A and 6B, the bridge patterns CP1 may be provided from a first conductive layer 220, and the plurality of second electrodes E2-1 to E2-7 and the sensing patterns SP1 may be provided from a second conductive layer 240. The bridge pattern CP1 may be connected to the sensing patterns SP1 through a contact hole TH-I defined in a second insulation layer 230. However, an embodiment of the inventive concept is not necessarily limited thereto. For example, in an embodiment of the inventive concept, the bridge patterns CP1 may be provided from the second conductive layer 240, and the plurality of second electrodes E2-1 to E2-7 and the sensing patterns SP1 may be provided from the first conductive layer 220. Each of the first conductive layer 220 and the second conductive layer 240 may have a three-layer structure of titanium/aluminum/titanium.

In this embodiment, each of the first signal lines SL1 and the second signal lines SL2 in FIG. 6A may be provided from the first conductive layer 220 in FIG. 6B. Thus, each of the first signal lines SL1 and the second signal lines SL2 in FIG. 6A may be disposed on the same layer as the bridge pattern CP1 in FIG. 6B. However, an embodiment of the inventive concept is not necessarily limited thereto, and each of the first signal lines SL1 and the second signal lines SL2 may be provided from the second conductive layer 240. Alternatively, each of the first signal lines SL1 and the second signal lines SL2 may include both a line provided from the first conductive layer 220 and a line provided from the second conductive layer 240.

In a case in which a display device such as a tablet computer having a larger surface area than a mobile terminal applies, respective lengths of the first electrodes E1-1 to E1-4 and the second electrodes E2-1 to E2-7 are increased, and thus a load applied to the electrodes is increased. The increase in load causes, for example, RC delay.

In order to prevent this phenomenon, a thickness of each of the first electrodes E1-1 to E1-4 and the second electrodes E2-1 to E2-7 may be increased. When the thicknesses of the first electrodes E1-1 to E1-4 and the second electrodes E2-1 to E2-7 are increased, a stepped portion due to these electrodes may be generated. According to this embodiment, in order to prevent the stepped portion from being generated due to the first electrodes E1-1 to E1-4 and the second electrodes E2-1 to E2-7, the second insulation layer 230 may provide a flat surface while covering the bridge patterns CP1, and a third insulation layer 250 may provide a flat surface while covering the sensing patterns SP1 and the sensing portions SP2. The second insulation layer 230 and the third insulation layer 250 may each include an organic material.

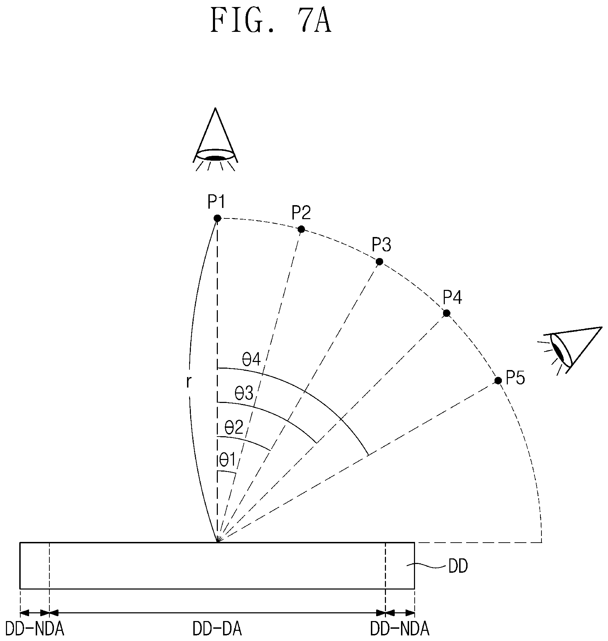

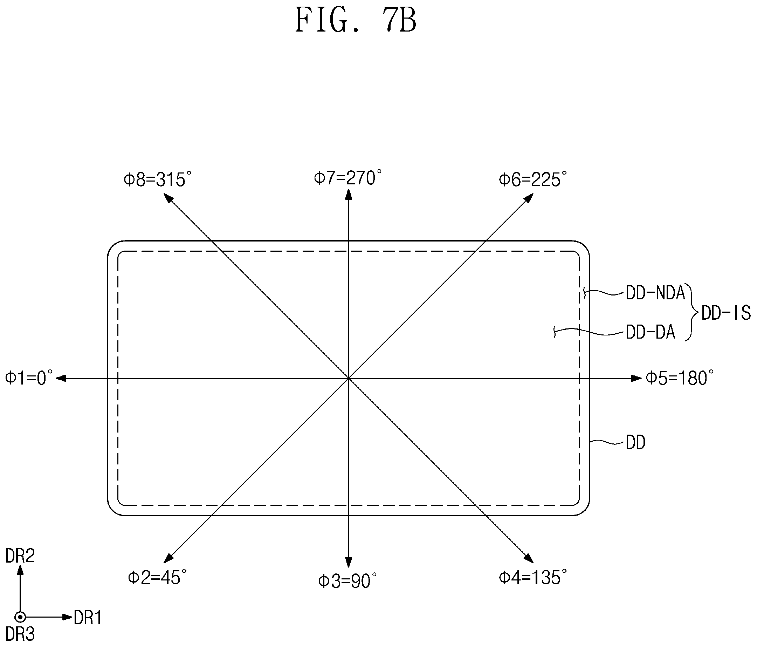

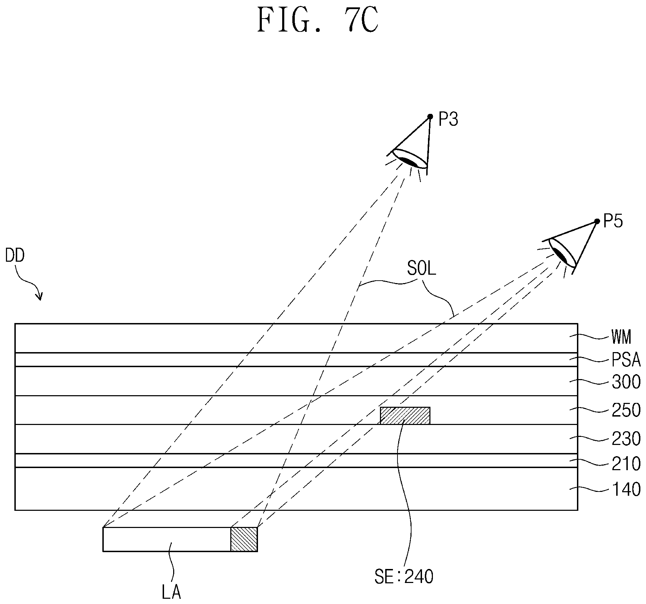

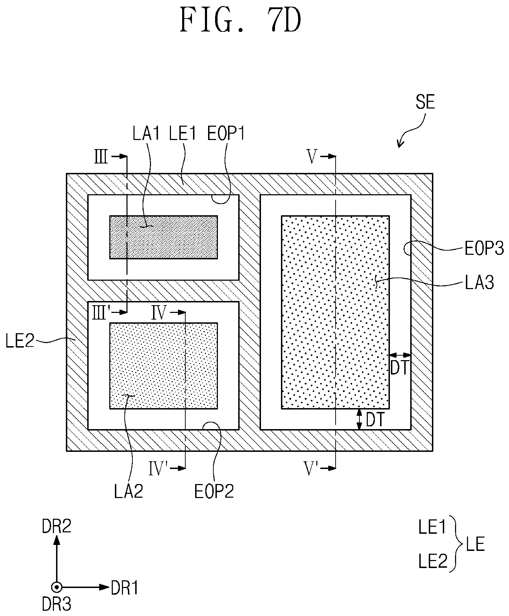

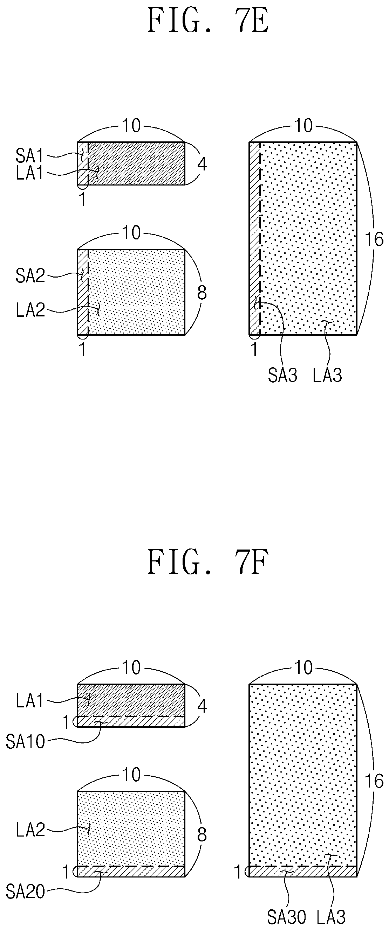

FIGS. 7A and 7B are views illustrating a spherical coordinate system defined in a display device DD. FIG. 7C is a cross-sectional view illustrating a radiation path of source light. FIG. 7D is an enlarged plan view of a partial area in FIG. 6A. FIGS. 7E and 7F are plan views illustrating shielding areas of light emitting areas.

According to the display device DD described with reference to FIGS. 1 to 6B, since the input sensor 200 is disposed above the display panel 100, the line elements of the input sensor 200 may interfere with the radiation path of the source light. Accordingly, a wavelength shift of a white image in which the white image is differently perceived at a specific azimuth angle and viewing angle may occur. Hereinafter, a cause of the wavelength shift of the white image will be described in detail with reference to FIGS. 7A to 7F.

As illustrated in FIGS. 7A and 7B, the spherical coordinate system may be defined in the display device DD. A point of origin of the spherical coordinate system may be located at a center of an image area DD-DA of the display device DD. The spherical coordinate system is used in distinguishing measurement points at which display quality of the display device DD is measured.

A coordinate of the spherical coordinate system may be represented as (r, θ, and Φ). Here, r represents a distance from the point of origin to each of the measurement points, θ represents an angle between a z axis (or normal axis of the display device DD) and a straight line defined between the point of origin and the measurement point, and Φ represents an angle between an x axis (or horizontal axis passing through the center of the display device DD) and a straight line obtained by projecting the straight line defined between the point of origin and the measurement point onto an x-y plane (or display surface of the display device DD). For convenience of explanation, θ is defined as a viewing angle, and Φ is defined as an azimuthal angle.

FIG. 7A illustrates five measurement points P1 to P5. A first viewing angle of a first measurement point P1 is defined as about 0°. Each of second to fifth viewing angles θ1, θ2, θ3 and θ4 has a constant angle from the z axis (or normal axis to the display device DD). The second to fifth viewing angles θ1, θ2, θ3 and θ4 of second to fifth measurement points P2 to P5 may be about 15°, about 30°, about 45°, and about 60°, respectively. Alternatively, the second to fifth viewing angles θ1, θ2, θ3 and θ4 of the second to fifth measurement points P2 to P5 may be about 20°, about 40°, about 60°, and about 80°, respectively. Alternatively, the second to fifth viewing angles θ1, θ2, θ3 and θ4 of the second to fifth measurement points P2 to P5 may be about 10°, about 20°, about 30°, and about 40°, respectively.

As an example, FIG. 7B illustrates eight azimuthal angles Φ1 to Φ8. First to eighth azimuthal angles Φ1 to Φ8 may be about 0°, about 45°, about 90°, about 135°, about 180°, about 225°, about 270°, and about 315°, respectively.

When all of the first light emitting area LA1, the second light emitting area LA2, and the third light emitting area LA3 illustrated in FIG. 4A emit light, the first color light, the second color light, and the third color light are mixed to display a white image. A color coordinate of a white image measured at the first measurement point P1 may serve as a reference value. A luminance or a wavelength range of each of the first color light, the second color light, and the third color light may be adjusted so as to ideally control the color coordinate of the white image measured at the first measurement point P1.

Referring to FIG. 7C, when a light emitting area LA is viewed at the third measurement point P3, a shielding phenomenon (light blocking phenomenon) due to a sensing electrode SE might not occur, and substantially the same white image as the white image measured at the first measurement point P1 (FIG. 7A) may be measured at the third measurement point P3.

However, when the light emitting area LA is viewed at the fifth measurement point P5, the shielding phenomenon (light blocking phenomenon) due to the sensing electrode SE may occur, and a white image different from the white image measured at the first measurement point P1 (FIG. 7A) may be measured at the fifth measurement point P5. This phenomenon in which the white image different from that of the first measurement point P1 is measured is a wavelength shift phenomenon of the white image. The wavelength shift phenomenon of the white image may occur differently according to the azimuth angle.

As described with reference to FIGS. 6A and 6B, a thickness of the sensing electrode SE is increased so as to reduce resistance, and a thickness of insulation layers 230 and 250 is increased so as to remove a stepped portion due to the sensing electrode SE. Thus, the shielding phenomenon due to the sensing electrode SE may more easily occur. For example, as the thickness of the sensing electrode SE is increased, and the thickness of the insulation layers 230 and 250 is increased, a range of a viewing angle at which the wavelength shift phenomenon of the white image does not occur is decreased, and a range of a viewing angle at which the wavelength shift phenomenon of the white image occurs is increased.

FIG. 7D is an enlarged view illustrating the display area 100-DA described with reference to FIG. 4A and a sensing electrode SE corresponding thereto.

A first light emitting area LA1, a second light emitting area LA2, and a third light emitting area LA3 may have different surface areas. In this embodiment, the first light emitting area LA1 may have the smallest surface area, and the third light emitting area LA3 may have the largest surface area. Hereinafter, light emitting surface areas of the first light emitting area LA1, the second light emitting area LA2, and the third light emitting area LA3 are defined as a first surface area, a second surface area, and a third surface area, respectively.

In this embodiment, the first light emitting area LA1, the second light emitting area LA2, and the third light emitting area LA3 which have the same width in the first direction DR1 are illustrated. The first light emitting area LA1 may have the smallest width in the second direction DR2, and the third light emitting area LA3 may have the largest width in the second direction DR2.

A line element LE may define a first opening area EOP1, a second opening area EOP2, and a third opening area EOP3 corresponding to the first light emitting area LA1, the second light emitting area LA2, and the third light emitting area LA3, respectively. The first opening area EOP1, the second opening area EOP2, and the third opening area EOP3 have larger surface areas than the corresponding light emitting areas LA1, LA3 and LA3, respectively. The first opening area EOP1 may have the smallest surface area, and the third opening area EOP3 may have the largest surface area.

The line element LE may include a first line element LE1 extending in the first direction DR1, and a second line element LE2 extending in the second direction DR2. The first line element LE1 and the second line element LE2 having a uniform line width are illustrated as an example, but an embodiment of the inventive concept is not necessarily limited thereto. Each of the first opening area EOP1, the second opening area EOP2, and the third opening area EOP3 may be defined by two first line elements LE1 and two second line elements LE2.

The sensing electrode SE in which a spaced distance DT from the line element LE to each of the first light emitting area LA1, the second light emitting area LA2, and the third light emitting area LA3 is the same is illustrated as an example. All of the respective spaced distances DT from the first line elements LE1 to the first light emitting area LA1, the second light emitting area LA2, and the third light emitting area LA3, and the respective spaced distances DT from the second line elements LE1 to the first light emitting area LA1, the second light emitting area LA2, and the third light emitting area LA3 may be the same. The spaced distance DT from the line element LE to each of the first light emitting area LA1, the second light emitting area LA2, and the third light emitting area LA3 is measured based on the same reference.

The shielding phenomenon described with reference to FIG. 7C is illustrated in FIGS. 7E and 7F.

FIG. 7E illustrates respective shielding areas SA1, SA2 and SA3 of the first light emitting area LA1, the second light emitting area LA2, and the third light emitting area LA3. When the first light emitting area LA1, the second light emitting area LA2, and the third light emitting area LA3 in FIG. 7D are viewed at a measurement point with the third viewing angle θ2 (see FIG. 7A) and the first azimuthal angle Φ1 (see FIG. 7B), the respective shielding areas SA1, SA2 and SA3 of the first light emitting area LA1, the second light emitting area LA2, and the third light emitting area LA3 are generated due to the second line element LE2 in FIG. 7D.

Referring to FIG. 7C, in the third direction DR3, a distance from the sensing electrode SE to the light emitting area LA may affect the shielding phenomenon of source light SOL. As the distance from the sensing electrode SE to the light emitting area LA is increased, a surface area of the shielding area may be increased. Hereinafter, an embodiment will be described with reference to FIGS. 7E and 7F on the assumption that a relative position of the sensing electrode SE to each of the first light emitting area LA1, the second light emitting area LA2, and the third light emitting area LA3 is the same.

In FIG. 7E, numerical values shown in the first light emitting area LA1, the second light emitting area LA2, and the third light emitting area LA3 are expressed in terms of relative ratios between lengths of indicated sides of the areas. The shielding area SA1 (hereinafter referred to as a first shielding area) of the first light emitting area LA1 amounts to about 4/40 an entire surface area of the first light emitting area LA1. The shielding area SA2 (hereinafter referred to as a second shielding area) of the second light emitting area LA2 amounts to about 8/80 an entire surface area of the second light emitting area LA2. The shielding area SA3 (hereinafter referred to as a third shielding area) of the third light emitting area LA3 amounts to about 16/160 an entire surface area of the third light emitting area LA3. For example, proportions of the first shielding area SA1, the second shielding area SA2, and the third shielding area SA3 to the corresponding light emitting areas are each about 1/10 and are the same.

FIG. 7F illustrates a first shielding area SA10, a second shielding area SA20, and a third shielding area SA30 generated, respectively, in the first light emitting area LA1, the second light emitting area LA2, and the third light emitting area LA3 in FIG. 7D, when the first light emitting area LA1, the second light emitting area LA2, and the third light emitting area LA3 in FIG. 7D are viewed at a measurement point with the fifth viewing angle θ4 (see FIG. 7A) and the third azimuthal angle Φ3 (see FIG. 7B). The first shielding area SA10 amounts to about 10/40 the entire surface area of the first light emitting area LA1, the second shielding area SA20 amounts to about 10/80 the entire surface area of the second light emitting area LA2, and the third shielding area SA30 amounts to about 10/160 the entire surface area of the third light emitting area LA3. Proportions of the first shielding area SA10, the second shielding area SA20, and the third shielding area SA30 to the corresponding light emitting areas are different.

When the first light emitting area LA1, the second light emitting area LA2, and the third light emitting area LA3 in FIG. 7D are viewed at the measurement point with the fifth viewing angle θ4 (see FIG. 7A) and the third azimuthal angle Φ3 (see FIG. 7B), the shielding area is generated due to the first line element LE1 in each of the first to third light emitting areas LA1, LA2 and LA3. A shielding ratio of the first light emitting area LA1 due to the first line element LE1 is the highest, and a shielding ratio of the third light emitting area LA3 due to the first line element LE1 is the lowest. The "high shielding ratio" means that a small proportion of source light generated from a corresponding light emitting area is provided to a measurement point.

A proportion of the first shielding area SA10 to the first light emitting area LA1 is the highest. This means that an amount of the first-color light provided to the measurement point with the fifth viewing angle θ4 (see FIG. 7A) and the third azimuthal angle Φ3 (see FIG. 7B) is decreased.

As described with reference to FIG. 7E, in the case in which the proportions of the first shielding area SA1, the second shielding area SA2, and the third shielding area SA3 to the corresponding light emitting areas are the same, the wavelength shift of the white image does not occur even when luminance of the white image is reduced. However, as described with reference to FIG. 7F, when source light having a specific color is provided to a lesser or greater extent than a measurement point, the wavelength shift of the white image may occur.

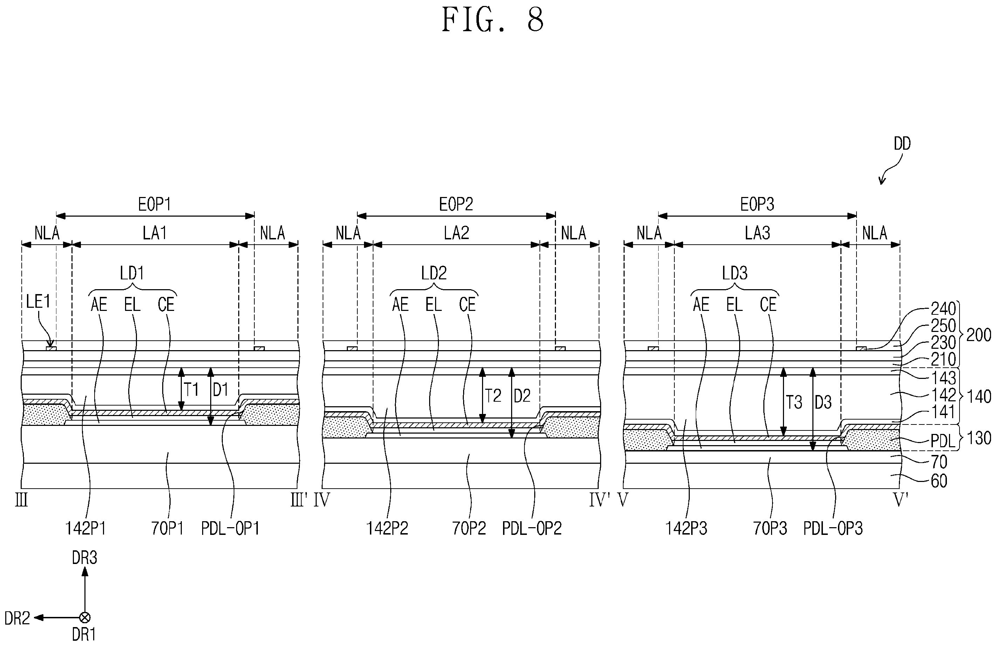

Hereinafter, an embodiment of the inventive concept which reduces the wavelength shift of the white image measured at the measurement point with the fifth viewing angle θ4 (see FIG. 7A) and the third azimuthal angle Φ3 (see FIG. 7B) will be described with reference to FIG. 8.

FIG. 8 is a cross-sectional view of a display device DD according to an embodiment of the inventive concept. In FIG. 8, a cross-section corresponding to line III-III' in FIG. 7D, a cross-section corresponding to line IV-IV' in FIG. 7D, and a cross-section corresponding to line V-V' in FIG. 7D are compared and illustrated as one cross-section. In FIG. 8, to the extent that an element is not described in detail with respect to this figure, it may be understood that the element is at least similar to a corresponding element that has been described elsewhere within the present disclosure such as with respect to FIGS. 7A to 7F. For example, components below a sixth insulation layer 60 are not illustrated compared to the cross-section in FIG. 5.

A first light emitting element LD1 (or first color light emitting element), a second light emitting element LD2 (or second color light emitting element), and a third light emitting element LD3 (or third color light emitting element) correspond to a first light emitting area LA1, a second light emitting area LA2, and a third light emitting area LA3, respectively. An anode AE of the first light emitting element LD1, an anode AE of the second light emitting element LD2, and an anode AE of the third light emitting element LD3 are exposed by a first opening PDL-OP1, a second opening PDL-OP2, and a third opening PDL-OP3, respectively.

According to this embodiment, a first distance D1 between the first light emitting element LD1 and an input sensor 200 in the third direction DR3 is less than a second distance D2 between the second light emitting element LD2 and the input sensor 200. The second distance D2 is less than a third distance D3 between the third light emitting element LD3 and the input sensor 200 in the third direction DR3. In this embodiment, each of the first distance D1, the second distance D2, and the third distance D3 may be measured as a distance between a top surface of a seventh insulation layer 70, with which the anode AE is in contact, and a bottom surface of a first insulation layer 210 of the input sensor 200. However, respective measurement references of the first distance D1, the second distance D2, and the third distance D3 are sufficient as long as the measurement references are the same, and are not necessarily limited to the foregoing reference. For example, in an embodiment of the inventive concept, each of the first distance D1, the second distance D2, and the third distance D3 may be measured as a distance between a top surface of the anode AE and a top surface of a second insulation layer 230, on which a second conductive layer 240 is disposed.

In a case in which the distance between the input sensor 200 and each of the first light emitting element LD1, the second light emitting element LD2, and the third light emitting element LD3 is the same, as described with reference to FIGS. 7D and 7F, the smaller the surface area of the light emitting area is, the higher the shielding ratio due to the first line element LE1 is. As illustrated in FIG. 8, when a light emitting element having a light emitting area having a small surface area is disposed adjacent to the input sensor 200, the shielding phenomenon due to the first line element LE1 may be decreased.

On the assumption that each of the first shielding area SA10, the second shielding area SA20, and the third shielding area SA30 described with reference to FIG. 7F is generated on the basis of the third distance D3, in a case in which the third distance D3 is decreased to the first distance D1 as illustrated in FIG. 8, the surface area of the first shielding area SA10 is decreased, and in a case in which the third distance D3 is decreased to the second distance D2 as illustrated in FIG. 8, the surface area of the second shielding area SA20 is also decreased. The surface area of the first shielding area SA10 is further decreased as compared to the surface area of the second shielding area SA20. As a result, the distance between the input sensor 200 and each of the first light emitting element LD1, the second light emitting element LD2, and the third light emitting element LD3 in the third direction DR3 may be differentially applied, thereby reducing a shielding ratio deviation due to the first line element LE1.

The seventh insulation layer 70 may include a first area 70P1 overlapping the first light emitting element LD1, a second area 70P2 overlapping the second light emitting element LD2, and a third area 70P3 overlapping the third light emitting element LD3. The anode AE of the first light emitting element LD1 is disposed on a first area 70P1 of the seventh insulation layer 70 and is in contact with the first area 70P1. The anode AE of the second light emitting element LD2 is disposed on a second area 70P2 of the seventh insulation layer 70 and is in contact with the second area 70P2. The anode AE of the third light emitting element LD3 is disposed on a third area 70P3 of the seventh insulation layer 70 and is in contact with the third area 70P3. A thickness of the seventh insulation layer 70 may be adjusted according to the areas, thereby adjusting the distance between the input sensor 200 and each of the first light emitting element LD1, the second light emitting element LD2, and the third light emitting element LD3 in the third direction DR3.

The first area 70P1 may have a larger thickness than the second area 70P2, and the second area 70P2 may have a larger thickness than the third area 70P3. A preliminary organic layer may be provided, and then a thickness of a portion of the preliminary organic layer may be reduced to be different for each of the areas by using a halftone mask. This provided seventh insulation layer 70 may have a single uninterrupted structure (e.g., a single integrated body).

Since the respective thicknesses of the first area 70P1, the second area 70P2, and the third area 70P3 are different, a stepped portion may be generated therebetween. For example, as respective bottom surfaces of the first area 70P1, the second area 70P2, and the third area 70P3 in FIG. 8 are disposed at the same position, but respective top surfaces of the first area 70P1, the second area 70P2, and the third area 70P3 are disposed at different positions, when the first area 70P1, the second area 70P2, and the third area 70P3 are connected to each other, an inclined area may be disposed in a border area therebetween.

In this embodiment, an example in which the thickness of the seventh insulation layer 70 is adjusted according to the areas is illustrated, but an embodiment of the inventive concept is not necessarily limited thereto. For example, in an embodiment of the inventive concept, a thickness of the sixth insulation layer 60 may be adjusted according to the areas. Alternatively, an additional insulation layer may be further disposed on only a specific area.

Even though the distance between the input sensor 200 and each of the first light emitting element LD1, the second light emitting element LD2, and the third light emitting element LD3 in the third direction DR3 is different, the input sensor 200 may have a flat sensing surface for improvement in sensing sensitivity. When a thickness of a thin-film encapsulation layer 140 is adjusted according to the areas to provide a flat base surface to the input sensor 200, the input sensor 200 provided on the flat base surface may have the flat sensing surface.

The base surface may be provided by an inorganic encapsulation layer 143. The thin-film encapsulation layer 140 including an organic encapsulation layer 142 having a different thickness among the areas is illustrated as an example. The organic encapsulation layer 142 may include a first area 142P1 overlapping the first light emitting element LD1, a second area 142P2 overlapping the second light emitting element LD2, and a third area 142P3 overlapping the third light emitting element LD3.

The first area 142P1 may have a smaller thickness than the second area 142P2, and the second area 142P2 may have a smaller thickness than the third area 142P3. When a liquid organic material is provided on an inorganic encapsulation layer 141 through an inkjet process, the liquid organic material is spread so as to compensate for the stepped portion generated due to the seventh insulation layer 70. The organic encapsulation layer 142 which provides a flat top surface may be formed through a curing process.

The first area 142P1 having the smaller thickness may overlap the first area 70P1 having the larger thickness, and the third area 142P3 having the larger thickness may overlap the third area 70P3 having the smaller thickness, so that the organic encapsulation layer 142 compensates for the stepped portion generated due to the seventh insulation layer 70.

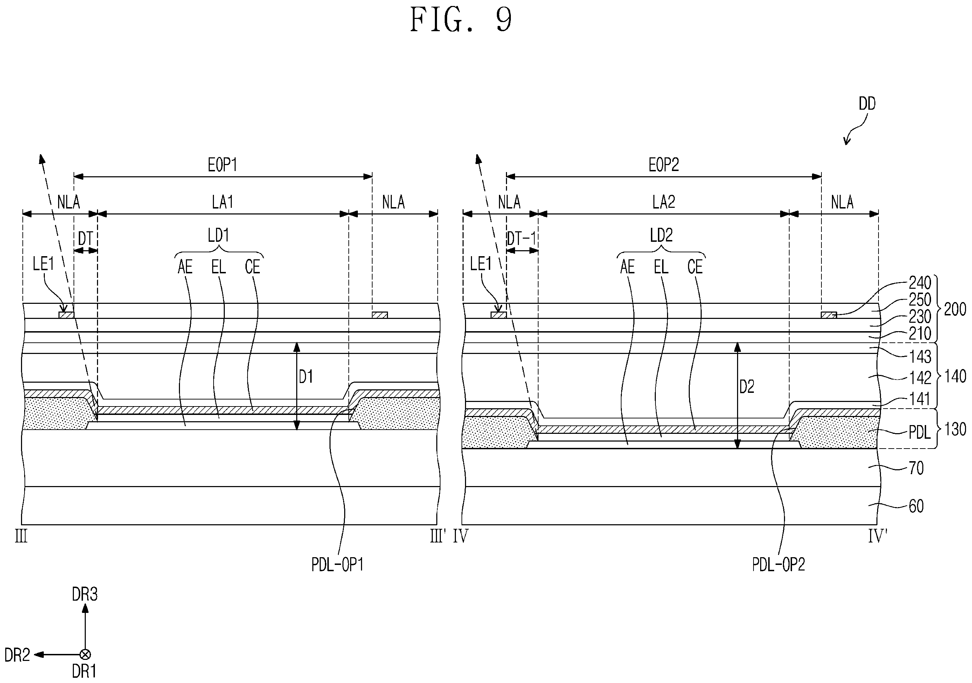

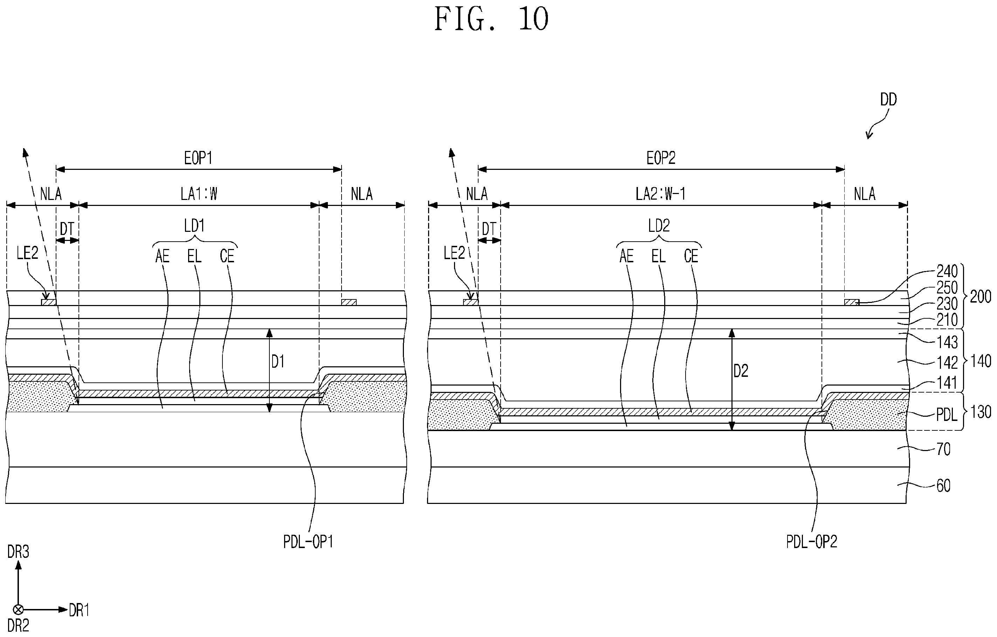

FIGS. 9 and 10 are cross-sectional views of a display device DD according to an embodiment of the inventive concept. Hereinafter, to the extent that an element is not described in detail with respect to this figure, it may be understood that the element is at least similar to a corresponding element that has been described elsewhere within the present disclosure, for example, with respect to FIGS. 7A to 8.

FIG. 9 shows a different cross-section in the second direction DR2 as FIG. 8, but FIG. 10 shows a different cross-section in the first direction DR1. FIGS. 9 and 10 each illustrate only a cross-section corresponding to the first light emitting area LA1 and the second light emitting area LA2 as a part of FIG. 8. The same relationship between the first light emitting area LA1 and the second light emitting area LA2 described below may apply to a relationship between the second light emitting area LA2 and a third light emitting area LA3.

Like the embodiment described with reference to FIG. 8, a first distance D1 is set to be smaller than a second distance D2, thereby reducing the surface area of the first shielding area SA10 in FIG. 7F. Here, for the same reason, the first shielding area SA10 in FIG. 7E may also be reduced. As a result, as the first distance D1 and the second distance D2 are set to be different, a shielding ratio due to a line element LE may be different among the first light emitting area LA1, the second light emitting area LA2, and the third light emitting area LA3.

In order to suppress occurrence of the wavelength shift of the white image, when a shielding ratio of the first light emitting area LA1 due to the first line element LE1 is decreased, a shielding ratio of the second light emitting area LA2 due to the first line element LE1 also needs to be decreased. This is because, in a case in which an amount of first color light provided to the measurement point with the third azimuthal angle Φ3 (see FIG. 7B) or the seventh azimuthal angle Φ7 (see FIG. 7B) increases, an amount of second color light and an amount of third color light, which are provided to the same measurement point, need to also be increased to prevent the wavelength shift of the white image from occurring.

As illustrated in FIG. 9, a spaced distance DT-1 between the first line element LE1 and the second light emitting area LA2 may be increased, thereby increasing the amount of the second-color light provided to the measurement point with the third azimuthal angle Φ3 (see FIG. 7B) or the seventh azimuthal angle Φ7 (see FIG. 7B). The spaced distance DT-1 between the first line element LE1 and the second light emitting area LA2 may be set to be greater than a spaced distance DT between the first line element LE1 and the first light emitting area LA1. At this time, it is assumed that the width of the first light-emitting area LA1 in the second direction DR2 and the width of the second light-emitting area LA2 in the second direction DR2 described in FIG. 7D are maintained.

Referring to FIG. 10, a width W-1 of the second light emitting area LA2 in the first direction DR1 may be increased so as to decrease the shielding ratio of the second light emitting area LA2 due to the first line element LE1. The width W-1 of the second light emitting area LA2 in the first direction DR1 may be set to be greater than a width W of the first light emitting area LA1 in the first direction DR1.

In this embodiment, a spaced distance DT between the first line element LE1 and the second light emitting area LA2 is equal to a spaced distance DT between the first line element LE1 and the first light emitting area LA1 like in FIG. 7D. In this embodiment, unlike the embodiment in FIG. 9 in which the spaced distance DT between the first line element LE1 and the second light emitting area LA2 is increased so as to decrease the shielding ratio of the second light emitting area LA2 due to the first line element LE1, the width W-1 of the second light emitting area LA2 in the first direction DR1 is increased compared to FIG. 7D. In this embodiment, a shielding area of the second light emitting area LA2 due to the first line element LE1 is not decreased, but a surface area of the second light emitting area LA2 is increased, thereby decreasing the shielding ratio of the second light emitting area LA2 due to the first line element LE1.

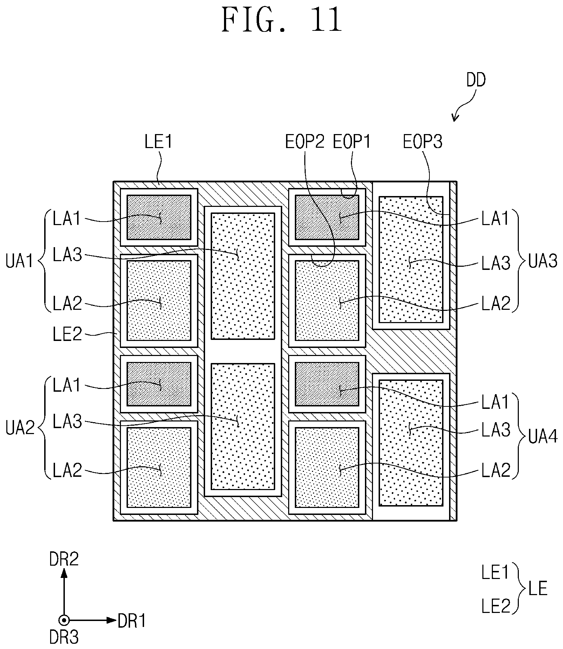

FIG. 11 is a plan view of a display device DD according to an embodiment of the inventive concept. To the extent that an element is not described in detail with respect to this figure, it may be understood that the element is at least similar to a corresponding element that has been described elsewhere within the present disclosure, such as with respect to FIGS. 4A to 8.

FIG. 11 is an enlarged view illustrating the display area 100-DA described with reference to FIG. 4A and a sensing electrode SE corresponding thereto.

A line element LE may define a first opening area EOP1, a second opening area EOP2, and a third opening area EOP3 corresponding to a first light emitting area LA1, a second light emitting area LA2, and a third light emitting area LA3, respectively. The line element LE may include a first line element LE1 extending in the first direction DR1, and a second line element LE2 extending in the second direction DR2.

The third opening area EOP3 substantially corresponds to the pair UP of light emitting areas described with reference to FIG. 4B. The first line element LE1 is not disposed between the third light emitting area LA3 of a first sub-area UA1 and the third light emitting area LA3 of a second sub-area UA2. Thus, with respect to the third light emitting area LA3 of the first sub-area UA1 and the third light emitting area LA3 of the second sub-area UA2, the shielding phenomenon described with reference to FIG. 7F occurs at only one of the third azimuthal angle Φ3 and the seventh azimuthal angle Φ7 in FIG. 7B. Except the foregoing, the same characteristics described with reference to FIGS. 7A to 10 may apply to the display device DD illustrated in FIG. 11.

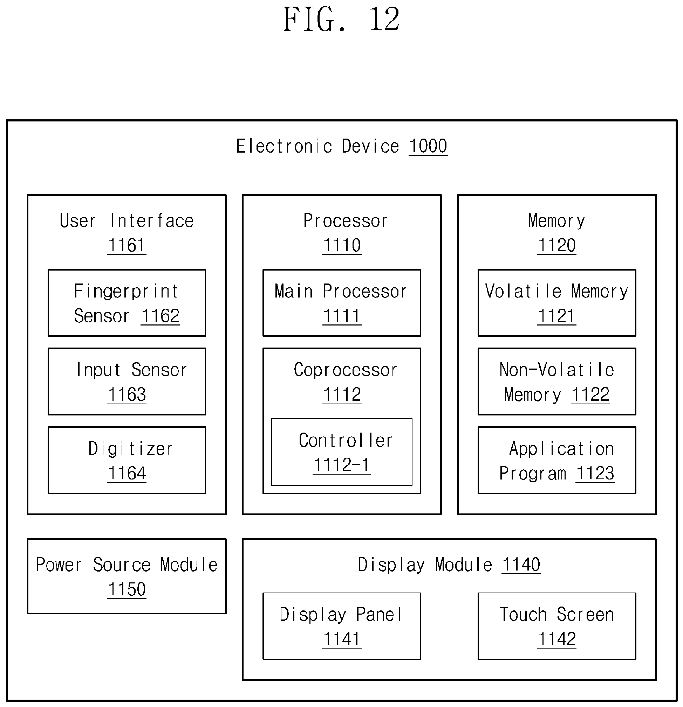

FIG. 12 is a diagram illustrating an electronic device according to an embodiment of the present invention. Referring to FIG. 12, the electronic device 1000 according to one embodiment of the present invention may output various information (e.g., images, text, music, etc.) through a display module 1140, which, for example, may correspond to the display device shown in FIG. 1. When a processor 1110 executes an application stored in a memory 1120, the display module 1140 may provide application information to a user through a display panel 1141.

In some embodiments, the electronic device 1000 may be configured as a smartphone, camera, smart TV, monitor, smartwatch, tablet, automotive display, or AR/VR headset. For example, the electronic device 1000 may be a smartphone including a touch-sensitive display area DA for interaction and a non-display area NDA including sensors and circuits for enhanced functionality. For example, the electronic device 1000 may be a television or monitor including a large display area DA for high-resolution video playback and a non-display area NDA incorporating driving circuits or connectivity modules for external inputs. For example, the electronic device 1000 may be a smartwatch including a display area DA optimized for compact and high-clarity visuals and a non-display area NDA integrating biometric sensors for health monitoring. In some cases, the electronic device 1000 be an AR/VR headset.

In some embodiments, memory 1120 may store information such as software codes for operating an application program 1123. The application program 1123 may include a software designed to execute specific tasks or provide functionality to a user. The application program 1123 may operate under the control of the processor 1110 and utilizes data stored in the memory 1120 to deliver a wide range of features, such as productivity tools, multimedia streaming and playback, file or mail deliveries or communication services. The application program 1123 interacts seamlessly with the user interface 1161 or touch screen 1142, allowing a user to launch, navigate, and utilize the program through user inputs such as touch, tap, gesture, or voice interaction.

Upon user selection of an application via touch screen 1142 or user interface 1161, the processor 1110 may execute the application program 1123 corresponding to the selected application retrieved from the memory 1120 to perform functionalities of the application. For example, when a user selects a camera application by tapping the icon (or a camera application icon) presented on the display panel 1141, the processor 1110 activates a camera module. The processor 1110 may transmit image data corresponding to a captured image acquired through the camera module to the display module 1140. The display module 1140 may display an image corresponding to the captured image through the display panel 1141.

As another example, when a user wishes to make a phone call, the user taps the telephone icon displayed on the display module 1140, the processor 1110 may execute a phone application program stored in the memory 1120. A telephone keypad may be presented on the display panel 1141 for the user to enter a phone number to call.

As another example, the display module 1140 may be integrated into an electronic device 1000, such as a laptop computer, smart TV, or tablet. A user wishing to access a multimedia streaming application (e.g., to watch a music video or movie) can do so by tapping the corresponding icon. This action activates the application, allowing the user to view the streamed content.

The processor 1110 may include a main processor 1111 and an auxiliary or coprocessor 1112. The main processor 1111 may include a central processing unit (CPU). The main processor 1111 may further include one or more of a graphics processing unit (GPU), a communication processor (CP), and an image signal processor (ISP).

The coprocessor 1112 may include a controller 1112-1. The controller 1112-1 may include an interface conversion circuit and a timing control circuit. The controller 1112-1 may receive an image signal from the main processor 1111, convert the data format of the image signal to match the interface specifications with the display module 1140, and output image data. The controller 1112-1 may output various control signals to drive the display module 1140. For example, the controller 1112-1 may drive the display module 1140 to display the icon on the display screen suitable for selection by a user to cause execution of an application program 1123.

The memory 1120 may store one or more application programs 1123 and various data used by at least one component (for example, the processor 1110 or the user interface 1161) of the electronic device 1000 and input data or output data for commands related thereto. For example, a camera application program, a GPS application program, an augmented reality and virtual reality application program, and other application programs that can be executed by the processor 1110 upon selection of corresponding icons presented on the display screen (or display panel 1141) via the touch screen 1142 or user interface 1161 by the user. In addition, various setting data corresponding to user settings may be stored in the memory 1120. The memory 1120 may include volatile memory 1121 and non-volatile memory 1122.

The display module 1140 may output visual information (images) to the user. The display module 1140 may include the display panel 1141, a gate driver, the source driver, a voltage generation circuit, and a touch screen 1142. The display module 1140 may further include a window, a chassis, and a bracket to protect the display panel 1141. The display module 1140 may include at least a part of the configuration of the display device shown in FIG. 1.

The user interface 1161 serves as the interaction medium between a user and the electronic device 1000. The user interface 1161 may detect an input by a part (e.g., finger) of a user's body or an input by a pen or a mouse, and generate an electric signal or data value corresponding to the input. The user interface 1161 includes the fingerprint sensor 1162, the input sensor 1163, and a digitizer 1164.

The fingerprint sensor 1162 may sense a fingerprint for biometric recognition of the user and may also measure one or more biological signals such as blood pressure, moisture, or body mass.

The input sensor 1163 may sense user interactions including touch, tap, gesture, motion, spoken command, and eye movement. The input sensor 1163 includes optical sensors for image capture, eye tracking, or motion and gesture detection. Optical sensors may be infrared or semiconductor photodetectors. The input sensor 1163 includes audio and acoustic sensors, which may be MEMS microphones for voice recognition or sound-based interaction. The audio and acoustic sensors can be installed as part of the user interface 1161 or embedded in the display panel 1141.

The digitizer 1164 may generate a data value corresponding to coordinate information of input by a pen or a mouse to control movement of an onscreen cursor. The digitizer 1164 may generate the amount of change in electromagnetic due to the input as the data value. The digitizer may detect an input by a passive pen or transmit and receive data with an active pen or a remote.

At least one of the fingerprint sensor 1162, the input sensor 1163, or the digitizer 1164 may be implemented as a sensor layer formed on the top layer of the display panel 1141 through a continuous process with a process of forming elements (for example, the light emitting element, the transistor, and the like) included in the display panel 1141.

In addition, the user interface 1161 may further include, for example, a gesture sensor, a gyro sensor that senses rotational movements, an acceleration sensor to track translational movement, a grip sensor, a pressure sensor, a proximity sensor, a color sensor, an infrared (IR) emitter and camera sensor for tracking gaze direction and eye movements, a temperature sensor, or a light sensor. For example, the gyro sensor, acceleration sensor, and infrared emitter and camera may be particularly suitable for AR/VR headset functions.

The touch screen 1142 includes touch sensors embedded in semiconductor layers of the display panel 1141 to sense pressure applied to the top layer (screen) of the display panel 1141. The touch sensors can be a capacitive or a resistive type. The touch screen 1142 may serve as the primary interface for the user to select and navigate applications, control, and interact with the electronic device 1000.

The display panel 1141 (or display) may include a liquid crystal display panel, an organic light emitting display panel, or an inorganic light emitting display panel, and the type of the display panel 1141 is not particularly limited. The display panel 1141 may be of a rigid type or a flexible type that can be rolled or folded. The display module 1140 may further include a supporter, bracket, heat dissipation member, and the like that support the display panel 1141. The display panel 1141 may include the display unit shown in FIG. 1.

The power source module 1150 may supply power to the components of the electronic device 1000. The power source module 1150 may include a battery that charges the power source voltage. The battery may include a non-rechargeable primary battery or a rechargeable secondary battery or fuel cell. The power source module 1150 may include a power management integrated circuit (PMIC). The PMIC may supply optimized power source to each of the components described above including the display module 1140.

According to the embodiments described above, the wavelength shift of the white image in which the white image is differently perceived at the specific azimuth angle and viewing angle may be reduced. As the result, the display device may have the increased display quality.

Although the embodiments of the present invention have been described, it is understood that the present invention should not necessarily be limited to these embodiments but various changes and modifications can be made by one ordinary skilled in the art within the scope of the claims.

## Claims

1. A display device, comprising:
a display panel comprising an organic layer, a light emitting element disposed on the organic layer, and a thin-film encapsulation layer sealing the light emitting element; and
an input sensor disposed on the display panel and comprising a sensing electrode, the sensing electrode comprising a line element defining an opening area corresponding to the light emitting element,
wherein the light emitting element comprises:
a first light emitting element configured to provide a first light emitting area having a first surface area; and
a second light emitting element configured to provide a second light emitting area having a second surface area that is greater than the first surface area, and
wherein a first distance between the first light emitting element and the input sensor is less than a second distance between the second light emitting element and the input sensor in a thickness direction of the display device.

2. The display device of claim 1, wherein the organic layer comprises:
a first area overlapping the first light emitting element; and
a second area overlapping the second light emitting element,
wherein a thickness of the first area is greater than a thickness of the second area.

3. The display device of claim 2, wherein the first area and the second area of the organic layer together have a single integrated body, and
wherein a step is defined between the first area and the second area of the organic layer.

4. The display device of claim 2 or 3, wherein an electrode of the first light emitting element is in contact with the first area of the organic layer, and an electrode of the second light emitting element is in contact with the second area of the organic layer.

5. The display device of claim 2, 3, or 4, wherein the thin-film encapsulation layer comprises:
a first area overlapping the first light emitting element; and
a second area overlapping the second light emitting element,
wherein a thickness of the first area of the thin-film encapsulation layer is less than a thickness of the second area of the thin-film encapsulation layer.

6. The display device of any one of claims 1 to 5, wherein a distance between the line element and the first light emitting area is equal to a distance between the line element and the second light emitting area.

7. The display device of any one of claims 1 to 6, further comprising a pixel defining layer disposed on the organic layer,
wherein each of the first light emitting element and the second light emitting element comprises a first electrode, a second electrode, and a light emitting layer disposed between the first electrode and the second electrode,
wherein a first opening exposing the first electrode of the first light emitting element and a second opening exposing the first electrode of the second light emitting element are defined in the pixel defining layer,
wherein the first electrode of the first light emitting element, which is exposed by the first opening, is defined as the first light emitting area, and the first electrode of the second light emitting element, which is exposed by the second opening, is defined as the second light emitting area.

8. The display device of any one of claims 1 to 7, wherein the line element comprises:
a first line element extending in a first direction; and
a second line element extending in a second direction crossing the first direction,
wherein each of the first light emitting area and the second light emitting area has a first width in the first direction and a second width in the second direction, and
wherein the first width of the first light emitting area is equal to the first width of the second light emitting area, and the second width of the first light emitting area is less than the second width of the second light emitting area.

9. The display device of claim 8, wherein a distance between the second line element and the second light emitting area is greater than a distance between the second line element and the first light emitting area.

10. The display device of claim 8 or 9, wherein a distance between the second line element and the first light emitting area is equal to a distance between the second line element and the second light emitting area, and
wherein the first width of the second light emitting area is greater than the first width of the first light emitting area.

11. The display device of any one of claims 1 to 10, wherein the input sensor further comprises a first insulation layer, a second insulation layer disposed on the first insulation layer, and a third insulation layer disposed on the second insulation layer, and
wherein the sensing electrode comprises first sensing portions, a bridge pattern connecting adjacent sensing portions of the first sensing portions, second sensing portions, and an intermediate portion disposed between adjacent sensing portions of the second sensing portions,
wherein the bridge pattern is disposed between the first insulation layer and the second insulation layer, and
wherein the first sensing portions, the intermediate portion, and the second sensing portions are disposed between the second insulation layer and the third insulation layer.

12. The display device of claim 11, wherein the first insulation layer comprises an inorganic material, and wherein the second insulation layer comprises an organic material and provides a flat surface.

13. The display device of any one of claims 1 to 12, wherein the light emitting element further comprises a third light emitting element configured to provide a third light emitting area having a third surface area that is greater than the second surface area, and
wherein a third distance between the third light emitting element and the input sensor is greater than the second distance between the second light emitting element and the input sensor.

14. The display device of claim 13, wherein the third light emitting element is spaced apart from the first light emitting element and the second light emitting element in a first direction, and
wherein the first light emitting element and the second light emitting element are spaced apart from each other in a second direction crossing the first direction.
